(19) Europäisches Patentamt
European Patent Office
Office européen des brevets

(11) **EP 2 133 924 A1**

(12) **EUROPEAN PATENT APPLICATION**
published in accordance with Art. 153(4) EPC

(43) Date of publication:
**16.12.2009 Bulletin 2009/51**

(51) Int Cl.:
***H01L 31/04*** *(2006.01)*

(21) Application number: **07792055.1**

(22) Date of filing: **06.08.2007**

(86) International application number:
**PCT/JP2007/065386**

(87) International publication number:
**WO 2008/099524 (21.08.2008 Gazette 2008/34)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **16.02.2007 JP 2007036432**

(71) Applicant: **Mitsubishi Heavy Industries, Ltd.**
**Tokyo 108-8215 (JP)**

(72) Inventors:
• **NAKANO, Youji**
**Nagasaki-shi**
**Nagasaki 851-0392 (JP)**

• **TAKEUCHI, Yoshiaki**
**Nagasaki-shi**
**Nagasaki 851-0392 (JP)**
• **YAMAGUCHI, Kengo**
**Nagasaki-shi**
**Nagasaki 851-0392 (JP)**
• **YAMAUCHI, Yasuhiro**
**Nagasaki-shi**
**Nagasaki 850-8610 (JP)**

(74) Representative: **Bongiovanni, Simone et al**
**Studio Torta S.r.l**
**Via Viotti 9**
**10121 Torino (IT)**

(54) **PHOTOELECTRIC CONVERTER AND METHOD FOR FABRICATING THE SAME**

(57) A photovoltaic device and a process for producing the photovoltaic device that combine a high photovoltaic conversion efficiency with a high level of productivity. The photovoltaic device includes at least a transparent electrode-bearing substrate, prepared by providing a transparent electrode layer 2 on a transparent, electrically insulating substrate 1, and a photovoltaic layer 92 containing mainly crystalline silicon-based semiconductors and a back electrode layer 4 formed sequentially on the transparent electrode layer 2 of the transparent electrode-bearing substrate, wherein the surface of the transparent electrode layer 2 of the transparent electrode-bearing substrate has a shape that contains a mixture of coarse and fine roughness, and exhibits a spectral haze ratio of 20% or greater for wavelengths of from 550 nm to 800 nm, and the photovoltaic layer containing mainly crystalline silicon-based semiconductors has a film thickness of from 1.2 $\mu$m to 2 $\mu$m, and a Raman ratio of from 3.0 to 8.0.

FIG. 1

90 ; PHOTOVOLTAIC DEVICE

1 ; SUBSTRATE
2 ; TRANSPARENT ELECTRODE LAYER
91 ; FIRST CELL LAYER (TOP LAYER)
93 ; TRANSPARENT ELECTRODE (INTERMEDIATE CONTACT LAYER)
3 ; PHOTOVOLTAIC LAYER
92 ; SECOND CELL LAYER (BOTTOM LAYER)
4 ; BACK ELECTRODE LAYER

EP 2 133 924 A1

**Description**

Technical Field

The present invention relates to a photovoltaic device and a process for producing the same, and relates particularly to a thin film silicon stacked solar cell that uses silicon as the electric power generation layer.

Background Art

The use of silicon-based thin-film photovoltaic devices as photovoltaic devices such as solar cells is already known. These photovoltaic devices generally comprise a first transparent electrode, a silicon-based semiconductor layer (a photovoltaic layer), a second transparent electrode, and a back electrode deposited sequentially on top of a substrate. The semiconductor layer has a pin junction formed by p-type, i-type, and n-type semiconductor materials. In those cases where the photovoltaic device is a solar cell, this pin junction functions as the energy conversion unit, converting the light energy from sunlight into electrical energy. This type of structure, wherein the photovoltaic device contains a single photovoltaic layer, is called a single structure.

Furthermore, in order to improve the photovoltaic conversion efficiency of the photovoltaic device, a method is used in which a plurality of photovoltaic layers formed from semiconductors with different band gaps are stacked together. This type of photovoltaic device that uses a plurality of stacked photovoltaic layers is called a multi-junction photovoltaic device, and structures in which two photovoltaic layers with different absorption wavelength bands are stacked are known as tandem structures, whereas structures containing three stacked layers are known as triple structures. Taking a tandem structure photovoltaic device as an example, an amorphous silicon that absorbs short wavelength light is used as the photovoltaic layer on the sunlight incident side of the device (hereafter also referred to as the "top cell"), and a crystalline silicon-based semiconductor such as a microcrystalline silicon that absorbs longer wavelength light is used as the photovoltaic layer on the opposite side to the sunlight incident surface (hereafter also referred to as the "bottom cell") in order to absorb the light not absorbed by the top cell.

For solar cells using this type of photovoltaic device, the following type of technical issue (1) exists.

(1) Increased Efficiency: How to most efficiently capture sunlight within the energy conversion unit, and how to increase the efficiency with which this solar energy is converted into electrical energy.

In terms of the increased efficiency described in the above technical issue (1), achieving an electric power generation efficiency of 12% or higher is a common benchmark, but conventionally, in order to achieve an electric power generation efficiency of 12% or higher in a tandem solar cell, for example, a bottom cell film thickness of not less than 2 $\mu$m has been required. Increasing the thickness of the bottom cell (to 3 $\mu$m or more) in order to further improve the electric power generation efficiency is currently under investigation.

Furthermore, in order to achieve the increased efficiency described in the above technical issue (1), increasing the haze ratio of the substrate incorporating the first transparent electrode is also under investigation. Conventionally, it has generally been thought that if the haze ratio of the substrate incorporating the first transparent electrode is increased, then although the light containment effect is improved by scattering of the incident light, which increases the electric power generation current, the open-circuit voltage and fill factor deteriorate dramatically due to the effects of the coarse roughness on the surface of the substrate incorporating the first transparent electrode, meaning the resulting structure is unsuitable as an electric cell. In order to overcome this problem, the use of a substrate with a transparent conductive oxide film, having a structure (a double textured structure) comprising macro-roughness (texture) formed from a plurality of discontinuous ridges and a plurality of flat portions that fill the regions between the ridges formed on top of a glass substrate, wherein the outer surfaces of the ridges and the flat portions contain a multitude of micro-roughness irregularities (texture), has been proposed as the above substrate and first transparent electrode (see patent citation 1 and patent citation 2). The substrate with a transparent conductive oxide film disclosed in the patent citations 1 and 2 exhibits favorable light scattering performance across the entire wavelength range of sunlight, and the patent citation 2 discloses, within the examples, that an amorphous silicon solar cell prepared using this structure is able to increase the photovoltaic conversion efficiency while substantially maintaining the open-circuit voltage and fill factor.

Patent Citation 1: PCT International Publication No. WO 03/036657A1
Patent Citation 2: Japanese Unexamined Patent Application, Publication No. 2005-347490

Disclosure of Invention

In order to enable practical application of a solar cell that uses a photovoltaic device, the following technical issue (2) exists in addition to the technical issue (1) described above.

(2) Productivity Improvement: How to best reduce the thickness of the i-layer within the crystalline silicon-based photovoltaic layer, which represents a bottleneck to improved productivity.

Because the production time for a solar cell is limited by the time taken to produce the i-layer within the crystalline silicon-based photovoltaic layer that constitutes the bottom cell or the like, reducing the thickness of the i-layer within the crystalline silicon-based photovoltaic layer is extremely effective in terms of the productivity described in the above technical issue (2). However, if the film thickness of the bottom cell within a tandem solar cell is reduced to less than 2 $\mu$m, then a dramatic reduction occurs in the electric power generation current, causing a marked decrease in the electric power generation efficiency. Consequently, even though the production time for the solar cell is lengthened considerably, a film thickness of at least 2 $\mu$m is typically used for the bottom cell.

In this manner, the technical issues (1) and (2) described above exist in a mutual trade-off type relationship.

The technique disclosed within the above patent citation 1 pays no particular consideration to the electric power generation efficiency of the photovoltaic layers comprising crystalline silicon-based semiconductors with different light absorption wavelength properties, and furthermore, makes no investigation of productivity improvements for solar cells. Accordingly, in the field of solar cells having a photovoltaic layer comprising crystalline silicon-based semiconductors, because the incident light absorption wavelength region differs considerably, particularly at longer wavelengths, a different containment shape is required for the roughness at the surface of the transparent electrode. However, an optimized shape for this roughness that takes due consideration of the need to reduce the film thickness of the crystalline silicon-based semiconductor has yet to be established, and technology that enables both increased efficiency for the electric power generation efficiency (addressing the technical issue (1)), and improved productivity for solar cells (addressing the technical issue (1)) has long been sought.

Furthermore, if a solar cell is produced using a substrate with a transparent conductive oxide film that includes a mixture of coarse and fine roughness, such as that disclosed in the patent citation 1, then although the reductions in the open-circuit voltage and fill factor are somewhat less than those observed for a substrate with a transparent conductive oxide film in which the haze ratio is increased using only coarse roughness structures, reductions in the open-circuit voltage and the fill factor are still noticeable.

The present invention has been developed in light of the above circumstances, and has an object of providing a photovoltaic device and a process for producing such a device that combine a high photovoltaic conversion efficiency with a high level of productivity.

Furthermore, another object of the present invention is to provide a photovoltaic device that uses a transparent electrode-bearing substrate in which the haze ratio has been increased by using a mixture of coarse and fine roughness, wherein a high photovoltaic conversion efficiency can be achieved with favorable suppression of any reductions in the open-circuit voltage and the fill factor, and also to provided a process for producing such a photovoltaic device.

In order to achieve the above objects, a photovoltaic device according to a first aspect of the present invention adopts the configuration described below.

Namely, a photovoltaic device according to a first aspect of the present invention comprises at least a transparent electrode-bearing substrate, prepared by providing a transparent electrode layer on a transparent, electrically insulating substrate, and a photovoltaic layer comprising mainly crystalline silicon-based semiconductors and a back electrode layer formed sequentially on the transparent electrode layer of the transparent electrode-bearing substrate, wherein the transparent electrode-bearing substrate has a surface shape comprising a mixture of coarse and fine roughness and exhibits a spectral haze ratio of 20% or greater for wavelengths of not less than 550 nm and not more than 800 nm, and the photovoltaic layer has a film thickness of not less than 1.2 $\mu$m and not more than 2 $\mu$m, and a Raman ratio of not less than 3.0 and not more than 8.0.

In the photovoltaic device according to the first aspect, by ensuring that the Raman ratio for the crystalline silicon-based photovoltaic layer is not less than 3.0 and not more than 8.0, a photovoltaic device can be obtained in which the crystal grain boundaries are suitably filled with amorphous silicon. As a result, current leakage at the crystal grain boundaries can be suppressed, meaning a photovoltaic device can be obtained in which reductions in the open-circuit voltage (Voc) and the fill factor (FF) are suppressed. When the transparent electrode-bearing substrate described above is used, crystal grain boundaries with large numbers of defects caused by the substrate roughness are formed more readily, and consequently, filling the crystal grain boundaries with amorphous silicon is particularly effective.

Furthermore, by forming an aforementioned photovoltaic layer comprising mainly crystalline silicon-based semiconductors in which the film thickness is not less than 1.2 $\mu$m and not more than 2 $\mu$m, even if the film thickness is reduced for the i-layer within the photovoltaic layer comprising mainly crystalline silicon-based semiconductors, a photovoltaic device with a large electric power generation current can be produced, the number of defects can be reduced by a quantity equivalent to the reduction in the film thickness, and because the potential gradient through the film thickness direction is large, the generated charge is less likely to be trapped by defects, enabling the production of a photovoltaic device in which reductions in the open-circuit voltage (Voc) and the fill factor (FF) have been suppressed. Accordingly, a photovoltaic device that combines both a reduced film thickness and a high conversion efficiency can be produced, and because the film thickness of the crystalline silicon-based i-layer is reduced, the production time for the photovoltaic device, which is limited by the time taken to produce this i-layer, can be shortened, enabling an improvement in the productivity for the photovoltaic device.

In general, the haze ratio refers to the haze ratio for light with a wavelength of approximately 550 nm, measured using a haze meter. If the haze ratio for a wavelength of 550 nm is high, then light with a wavelength of approximately 550 nm is scattered effectively, but for longer wavelength light, favorable scattering occurs when the haze ratio for the longer wavelength is high, whereas scattering is less likely when the haze ratio for the wavelength is low. In the case of a conventional one layer textured structure, even if the haze ratio for a wavelength of 550 nm is 30%, the spectral haze ratio for light with a wavelength of 800 nm is 5% or less, meaning the containment by scattering enhancement of light within the wavelength region from 700 to 900 nm, which is the wavelength region which the crystalline silicon-based photovoltaic layer should be aiming to contain, is inadequate. Furthermore, in the wavelength region below 350 nm, because the transmittance of the aforementioned transparent electrode substrate decreases, accurate measurement of the haze ratio becomes impossible. Accordingly, the haze ratio for wavelengths of not less than 550 nm and not more than 800 nm is defined by the spectral haze ratio measured using light of specific wavelengths, and by ensuring that this spectral haze ratio is at least 20%, and preferably 30% or greater, the scattering and containment of light in the wavelength region from 700 to 900 nm, which is strongly affected by the containment effect of the crystalline silicon-based photovoltaic layer, can be enhanced, thereby increasing the electric power generation current.

In the photovoltaic device according to the first aspect, a photovoltaic layer comprising mainly amorphous silicon-based semiconductors may be provided between the transparent electrode-bearing substrate, and the photovoltaic layer comprising mainly crystalline silicon-based semiconductors.

By employing this type of configuration, photovoltaic conversion of the short wavelength component of sunlight occurs within this photovoltaic layer comprising mainly amorphous silicon-based semiconductors, whereas photovoltaic conversion of the long wavelength component of sunlight occurs within the photovoltaic layer comprising mainly crystalline silicon-based semiconductors, and consequently a photovoltaic device with a high photovoltaic conversion efficiency can be obtained.

In the photovoltaic device according to the first aspect, an intermediate contact layer may be formed between the photovoltaic layer comprising mainly amorphous silicon-based semiconductors and the photovoltaic layer comprising mainly crystalline silicon-based semiconductors.

By including an intermediate contact layer, the film thickness of the photovoltaic layer comprising mainly amorphous silicon-based semiconductors can be reduced, enabling an improvement in the rate of degradation, although the quantity of incident light entering the photovoltaic layer comprising mainly crystalline silicon-based semiconductors is reduced, which causes a decrease in the electrical current. Accordingly, because of this inverse relationship between the improvement in the rate of degradation of the photovoltaic layer comprising mainly amorphous silicon-based semiconductors, and the decrease in the electric power generation current within the photovoltaic layer comprising mainly crystalline silicon-based semiconductors, the film thickness of the intermediate contact layer is preferably not more than 90 nm, and is even more preferably not less than 50 nm and not more than 70 nm. Furthermore, a ZnO-based film (such as a GZO film) is preferably formed as the intermediate contact layer, and the light absorption of the ZnO-based film within a range from $\lambda$ = 450 nm to 1,000 nm is preferably less than 1%. If the transparency of the intermediate contact layer is lost, then the quantity of incident light entering the photovoltaic layer comprising mainly crystalline silicon-based semiconductors is reduced, causing a decrease in the electric power generation current, and consequently the intermediate contact layer is preferably substantially transparent to light within the wavelength region from not less than 450 nm to not more than 1,000 nm.

In the photovoltaic device according to the first aspect, the surface of the transparent electrode of the transparent electrode-bearing substrate preferably comprises a plurality of ridges and a plurality of flat portions, and the surfaces of these ridges and flat portions preferably comprise a multitude of continuous micro-protrusions, wherein the height of the ridges in a direction perpendicular to the substrate surface is not less than 0.4 $\mu$m and not more than 0.7 $\mu$m, the number of ridges within a 10 $\mu$m square area of the substrate surface is not less than 15 and not more than 50, the base diameter of the multitude of micro-protrusions is not less than 0.1 $\mu$m and not more than 0.3 $\mu$m, and the ratio of height/base diameter for the micro-protrusions is not less than 0.7 and not more than 1.2.

By employing a transparent electrode-bearing substrate having the properties described above, the photovoltaic device according to the first aspect is able to generate a high electric power generation current even if the i-layer within the photovoltaic layer comprising mainly crystalline silicon-based semiconductors (for example, the bottom cell of a tandem solar cell) is a thin film, for example with a film thickness of 1.5 $\mu$m. Moreover, by reducing the thickness of the i-layer within the photovoltaic layer comprising mainly crystalline silicon-based semiconductors, reductions in the open-circuit voltage (Voc) and the fill factor (FF) can also be suppressed. In other words, by ensuring a reduced film thickness for the photovoltaic layer comprising mainly crystalline silicon-based semiconductors, the number of defects can be reduced by a quantity equivalent to the reduction in the film thickness, and because the potential gradient through the film thickness direction is large, the generated charge is less likely to be trapped by defects. Accordingly, a reduction in the film thickness and an increase in the efficiency of the photovoltaic device can be achieved simultaneously. In addition, because the film thickness of the i-layer within the crystalline silicon-based photovoltaic layer can be reduced, the production time for the photovoltaic device, which is limited by the time taken to produce this i-layer, can be shortened, enabling an improvement in the productivity for the photovoltaic device according to the first aspect.

It is thought that one reason that the open-circuit voltage and the fill factor decrease with the conventional technology is that discontinuous boundaries (hereafter these boundaries are referred to as hetero-phases) that extend from the valley portions of the transparent electrode in the direction of the film thickness of the photovoltaic layer are generated between growth phases of the film, and these boundaries act as a center for carrier recombination. It is thought that these hetero-phases are formed when growth surfaces conflict with each other during formation and growth of the silicon film from the various surfaces of the underlying film, with these conflicting surfaces forming lattice defects or microscopic cavities, resulting in losses via carrier recombination. These hetero-phases that extend in the direction of the film thickness of the photovoltaic layer can be detected by analyzing the cross-section of the photovoltaic layer using a transmission microscope. Inspection is conducted at a magnification of at least 80,000×, with the photovoltaic layer inspected over a length of 100 $\mu$m, and if a fissure is detected then hetero-phases are deemed to exist, and detection of even a single penetrating hetero-phase is deemed to indicate the existence of penetrating hetero-phases.

In order to suppress the actual generation of these hetero-phases, rather than simply increasing the scale of the roughness on the surface of the substrate with the transparent conductive oxide film, combining a mixture of coarse and fine roughness is more effective. However, even when an aforementioned transparent electrode is used, if film formation is conducted at a fast film growth rate of 1 nm/second or higher, then complete suppression of hetero-phase generation is impossible, meaning there are limits to the degree to which hetero-phase generation can be suppressed by appropriate selection of the film formation conditions employed during formation of the photovoltaic layer. As a result, the inventors of the present invention focused on discovering techniques wherein, even if hetero-phases are generated during high-speed film formation, those hetero-phases that penetrate right through the photovoltaic layer are able to be blocked.

Accordingly, the inventors of the present invention discovered that if these hetero-phases could be suppressed, or even if not completely suppressed, if hetero-phases penetrating the photovoltaic layer could be blocked, then decreases in the open-circuit voltage and fill factor could be suppressed.

Based on this discovery, and in order to achieve the objects described above, a photovoltaic device according to a second aspect of the present invention and a process for producing a photovoltaic device according to a third aspect adopt the configurations described below.

Namely, a photovoltaic device according to a second aspect of the present invention comprises at least a transparent electrode-bearing substrate, prepared by providing a transparent electrode layer on a transparent, electrically insulating substrate, and a photovoltaic layer comprising mainly amorphous silicon-based semiconductors and a back electrode layer formed sequentially on the transparent electrode layer of the transparent electrode-bearing substrate, wherein the transparent electrode-bearing substrate has a surface shape comprising a mixture of coarse and fine roughness and exhibits a spectral haze ratio of 20% or greater, and preferably 30% or greater, for wavelengths of not less than 550 nm and not more than 800 nm, and wherein either a layer (hereafter referred to as a hetero-phase-blocking layer) that blocks hetero-phases (discontinuous boundaries between film growth phases) from penetrating through the photovoltaic layer comprising mainly amorphous silicon-based semiconductors from the surface on the transparent electrode layer side to the surface on the back electrode layer side is provided within the photovoltaic layer, or a hetero-phase prevention layer that prevents the formation of hetero-phases that penetrate through the photovoltaic layer from the surface on the transparent electrode layer side to the surface on the back electrode layer side is provided between the substrate and the photovoltaic layer comprising mainly amorphous silicon-based semiconductors.

According to the photovoltaic device of the second aspect, hetero-phases that penetrate through the photovoltaic layer comprising mainly amorphous silicon-based semiconductors, from the surface on the transparent electrode layer side to the surface on the back electrode layer side, can be either blocked or prevented, meaning current leakage caused by these hetero-phases can be suppressed, thereby suppressing any reductions in the open-circuit voltage or the fill factor.

Furthermore, a process for producing a photovoltaic device according to a third aspect comprises: preparing a transparent electrode-bearing substrate by forming a transparent electrode layer on a transparent, electrically insulating substrate, and sequentially forming at least a photovoltaic layer comprising mainly amorphous silicon-based semiconductors and a back electrode layer on the transparent electrode layer of the transparent electrode-bearing substrate, wherein the surface of the transparent electrode of the transparent electrode-bearing substrate comprises a multitude of continuous protrusions, and either a hetero-phase-blocking layer that blocks hetero-phases from penetrating through the photovoltaic layer comprising mainly amorphous silicon-based semiconductors from the surface on the transparent electrode layer side to the surface on the back electrode layer side is formed within the photovoltaic layer, or a hetero-phase prevention layer that prevents the formation of hetero-phases that penetrate through the photovoltaic layer from the surface on the transparent electrode layer side to the surface on the back electrode layer side is formed between formation of the transparent electrode layer and formation of the photovoltaic layer comprising mainly amorphous silicon-based semiconductors.

According to the process for producing a photovoltaic device according to the third aspect, hetero-phases that penetrate through the photovoltaic layer comprising mainly amorphous silicon-based semiconductors, from the surface on the transparent electrode layer side to the surface on the back electrode layer side, can be either blocked or prevented, meaning current leakage caused by these hetero-phases can be suppressed, thereby enabling the production of a photovoltaic device for which any reductions in the open-circuit voltage or the fill factor have been suppressed.

In the photovoltaic device according to the second aspect and the process for producing a photovoltaic device according to the third aspect, the photovoltaic layer comprising mainly amorphous silicon-based semiconductors may be a layer prepared by sequential formation of a p-layer, an i-layer and an n-layer, wherein the hetero-phase-blocking layer is a layer produced as a portion of the i-layer that is formed at a slower rate than the p-layer, the n-layer, and the remaining portions of the i-layer. By forming the hetero-phase-blocking layer at a slower rate, the dispersion and migration time is increased for the film-forming particles at the film formation surface, enabling the formation of a layer in which the particles are deposited in more stable sites, yielding fewer defects, in other words, a layer with minimal hetero-phases. Furthermore, because the layer formed at a slower rate is only a thin portion of the i-layer, the processing time required for film formation at the slower rate has little effect on the overall production time, meaning a layer with minimal hetero-phases can be formed with favorable retention of the productivity level.

Alternatively, the photovoltaic layer comprising mainly amorphous silicon-based semiconductors may be a layer prepared by sequential formation of a p-layer, an n-layer and an i-layer, wherein either a portion of, or all of, the n-layer is formed as an amorphous layer, with this n-layer functioning as the aforementioned hetero-phase-blocking layer. The term "amorphous" refers to a layer for which absolutely no crystalline Si peaks are detected upon Raman spectroscopic analysis, and such a layer can be obtained by altering the film formation conditions, either by reducing the hydrogen gas / silane gas dilution ratio, or by reducing the RF power. In those cases where only the top surface of the layer is formed as an amorphous film, a peak may be detected for the underlying Si crystalline film during Raman spectroscopic analysis, and in such cases, a film is formed under a single set of conditions on either a glass substrate or a transparent electrode-bearing glass substrate, and this film is then subjected to Raman spectroscopic analysis to check for the presence of crystalline Si peaks. In an amorphous film, defects are terminated by hydrogen, meaning defects are less likely to interconnect in a continuous manner than in the case of a crystalline film, and therefore the amorphous film possesses a hetero-phase-blocking function.

Alternatively, the photovoltaic layer comprising mainly amorphous silicon-based semiconductors may be a layer prepared by sequential formation of a p-layer, an n-layer and an i-layer, wherein by forming at least a portion of the n-layer under a pressure of not less than 200 Pa, the n-layer is imparted with a hetero-phase-blocking function. When film formation is conducted under high pressure, collisional diffusion is promoted within the gas phase of the raw material gas used for the film formation, making the raw material gas more likely to reach into recessed portions of the underlying material, and therefore ensuring uniform film formation also occurs within these recessed portions, and as a result, it is thought that a favorably uniform film can be formed over any defects, meaning hetero-phases can be suppressed.

Alternatively, the aforementioned hetero-phase prevention layer may be the above transparent electrode layer in which the protrusions have been smoothed. When the protrusions are formed in a continuous manner, the valleys that are generated between the boundaries of the protrusions are usually formed of a combination of planar surfaces, meaning the bottoms of these valleys appear as sharp lines, and smoothing of the protrusions refers to a process of smoothing the bottom surfaces to remove these lines, forming a spoon-cut type shape.

The hetero-phase prevention layer may also be formed by subjecting the surface of the transparent electrode layer to an ion treatment. Ion treatment refers to ion etching, for example by argon ion irradiation within a vacuum, and enables the surface shape of the transparent electrode to be controlled via atomic level etching and redeposition. By adjusting the ion irradiation angle and the ion energy during the ion etching, atoms can be preferentially etched and removed from the sloped surfaces of the roughness on the transparent electrode, with redeposition occurring within the bottoms of the valley portions, and as a result, the sharp valley shapes can be smoothed.

In the photovoltaic device according to the second aspect and the process for producing a photovoltaic device according to the third aspect, the transparent electrode-bearing substrate preferably exhibits a spectral haze ratio of at least 20% for wavelengths of not less than 550 nm and not more than 800 nm. This spectral haze ratio is even more preferably 30% or greater.

As described above, in the case of a conventional textured structure, even if the spectral haze ratio for a wavelength of 550 nm is 30%, the spectral haze ratio for light with a wavelength of 800 nm is 5% or less, meaning the containment by scattering enhancement of light within the wavelength region from 700 to 900 nm, which is the wavelength region which the crystalline silicon-based photovoltaic layer should be aiming to contain, is inadequate. Accordingly, in the photovoltaic device according to the second aspect and the process for producing a photovoltaic device according to the third aspect, the size of the texture is increased, so that a higher level of haze is also achieved for longer wavelength light. Furthermore, in the wavelength region below 350 nm, because the transmittance of the transparent electrode substrate decreases, measurement of the haze ratio using a haze meter becomes impossible. Accordingly, by ensuring that the spectral haze ratio for wavelengths of not less than 550 nm and not more than 800 nm is at least 20%, and preferably 30% or greater, the scattering and containment of light within the wavelength region from 700 to 900 nm, which is strongly affected by the containment effect of the crystalline silicon-based semiconductor photovoltaic layer, can be enhanced, enabling the electric power generation current to be increased.

In the photovoltaic device according to the second aspect and the process for producing a photovoltaic device according to the third aspect, a photovoltaic layer comprising mainly crystalline silicon-based semiconductors may be formed between the photovoltaic layer comprising mainly amorphous silicon-based semiconductors, and the back electrode.

By employing this type of configuration, photovoltaic conversion of the short wavelength component of sunlight occurs within this photovoltaic layer comprising mainly amorphous silicon-based semiconductors, whereas photovoltaic conversion of the long wavelength component of sunlight occurs within the photovoltaic layer comprising mainly crystalline silicon-based semiconductors, and consequently a photovoltaic device with a high photovoltaic conversion efficiency can be obtained.

Furthermore, the photovoltaic layer comprising mainly crystalline silicon-based semiconductors is not limited to crystalline silicon-based semiconductors, and similar effects can be achieved when the photovoltaic layer comprises mainly crystalline or amorphous silicon-based semiconductors, or comprises mainly crystalline or amorphous silicon germanium-based semiconductors.

Furthermore, the photovoltaic device may also be a structure of three or more layers, comprising a photovoltaic layer comprising mainly crystalline silicon-based semiconductors, and a third photovoltaic layer. In such cases, the photovoltaic layer comprising mainly crystalline silicon-based semiconductors and the third photovoltaic layer may also be photovoltaic layers that comprise mainly crystalline or amorphous silicon-based semiconductors, or comprise mainly crystalline or amorphous silicon germanium-based semiconductors, and the materials, film properties and film thickness of each of the photovoltaic layers are preferably set so that the light absorption of the longer wavelength component increases sequentially for the photovoltaic layer comprising mainly amorphous silicon-based semiconductors, the photovoltaic layer comprising mainly crystalline silicon-based semiconductors, and the third photovoltaic layer.

According to the present invention, a photovoltaic device and production process therefor can be provided that combine a high photovoltaic conversion efficiency with a high level of productivity. The photovoltaic device of the present invention can be used favorably as a solar cell.

Furthermore, according to the present invention, a photovoltaic device can be provided that uses a transparent electrode-bearing substrate having a surface shape comprising a mixture of coarse and fine roughness that exhibits a spectral haze ratio of 20% or greater, and preferably 30% or greater, for wavelengths of not less than 550 nm and not more than 800 nm, wherein a high photovoltaic conversion efficiency can be achieved with favorable suppression of any reductions in the open-circuit voltage or the fill factor. Moreover, a process for producing this type of superior photovoltaic device can also be provided. The photovoltaic device of the present invention can be used favorably as a solar cell.

Furthermore, a high level of photovoltaic conversion efficiency can be obtained even when the thickness of the photovoltaic layer is reduced. This thickness reduction causes a small reduction in the electric power generation current, but this reduction in the electric power generation current can be dramatically improved compared with the case of a thickness reduction within a conventional substrate. Furthermore, this thickness reduction improves the open-circuit voltage and the fill factor. The reasons for this improvement are that reducing the thickness of the photovoltaic layer by forming thinner films reduces the quantity of defects within the photovoltaic layer by a quantity equivalent to the thickness reduction, and reduces the probability of charge recombination (quenching caused by defects) by increasing the potential gradient relative to the electromotive force generated within the photovoltaic layer.

Reducing the film thickness offers considerable merit from a productivity perspective. The time taken to produce each photovoltaic device can be shortened, and the frequency with which maintenance must be performed inside the film formation chamber of the production apparatus can also be reduced, meaning the production volume per unit of time and per production apparatus can be increased beyond the proportion by which the film thickness was reduced. Accordingly, from a production perspective, the improvement in productivity can be said to be more advantageous than the improvement in the photovoltaic conversion efficiency.

Brief Description of Drawings

[FIG. 1] A schematic view showing the structure of a photovoltaic device according to the present invention.
[FIG. 2] A partially cut-away cross-sectional view showing the shape and structure of a transparent electrode-bearing substrate used in a first embodiment of the present invention.
[FIG. 3] An enlarged view of a ridge 112 shown in FIG. 2.
[FIG. 4] A schematic view showing a portion of an embodiment of a process for producing a solar cell panel according to the present invention.

[FIG. 5] A schematic view showing a portion of an embodiment of a process for producing a solar cell panel according to the present invention.

[FIG. 6] A schematic view showing a portion of an embodiment of a process for producing a solar cell panel according to the present invention.

[FIG. 7] A schematic view showing a portion of an embodiment of a process for producing a solar cell panel according to the present invention.

[FIG. 8] An electron microscope photograph of the surface of a transparent electrode of a transparent electrode-bearing substrate prior to the ion treatment of a second embodiment of the present invention.

[FIG. 9] An electron microscope photograph of the surface of the transparent electrode of a transparent electrode-bearing substrate following the ion treatment of the second embodiment of the present invention.

[FIG. 10] A transmission electron microscope photograph of a cross-section of a tandem solar cell prepared using a transparent electrode-bearing substrate of the second embodiment of the present invention.

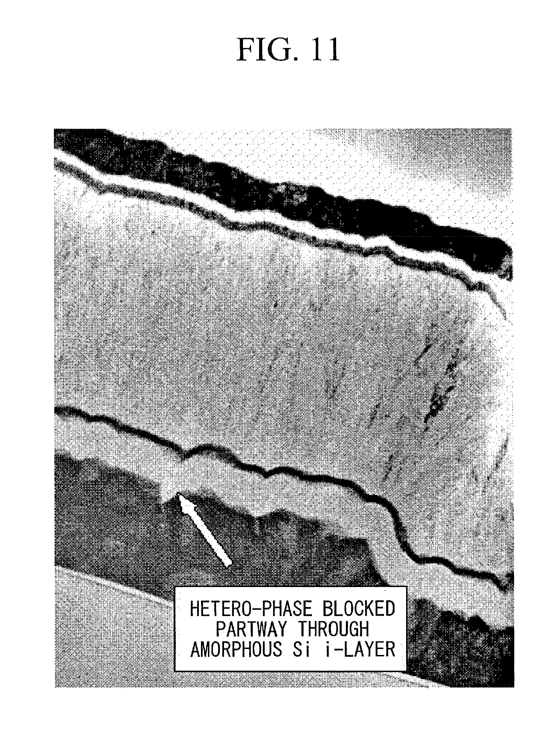

[FIG. 11] A transmission electron microscope photograph of a cross-section of a tandem solar cell prepared using a transparent electrode-bearing substrate of the second embodiment of the present invention. As described in an example 7, the latter stage of the film formation of the amorphous Si i-layer functions as a phase-blocking layer, suppressing the formation of hetero-phases that penetrate through the amorphous Si layer.

[FIG. 12] A graph showing the relationship between the Raman ratio following formation of the n-layer of the bottom cell, and the properties of the solar cell, for the tandem solar cell of an example 11.

Explanation of Reference:

| | |
|---|---|
| 1: | Substrate |
| 2: | Transparent electrode layer |
| 3: | Photovoltaic layer |
| 4: | Back electrode layer |
| 6: | Solar cell module |
| 90: | Photovoltaic device |
| 91: | First cell layer (top layer) |
| 92: | Second cell layer (bottom layer) |
| 93: | Intermediate contact layer |
| 110: | Transparent electrode-bearing substrate |
| 111: | Substrate |
| 112: | Ridge |
| 114: | Transparent electrode |
| 115: | Small ridge |
| 116: | Continuous layer |
| 117: | Protrusion |
| $H_a$: | Height of ridge |
| $P_a$: | Average pitch between ridges |
| $H_c$: | Height of small ridge |
| $P_c$: | Average pitch between small ridges |
| $H_b$: | Height of protrusion |
| $P_b$: | Pitch between protrusions |
| 15: | Insulation slot |
| 21: | Backing sheet |
| 23: | Output cable |
| 50: | Solar cell panel |

Best Mode for Carrying Out the Invention

First Embodiment

A first embodiment of the present invention is described below with reference to the drawings.

First is a description of the structure of a photovoltaic device produced using a process for producing a photovoltaic device according to this embodiment.

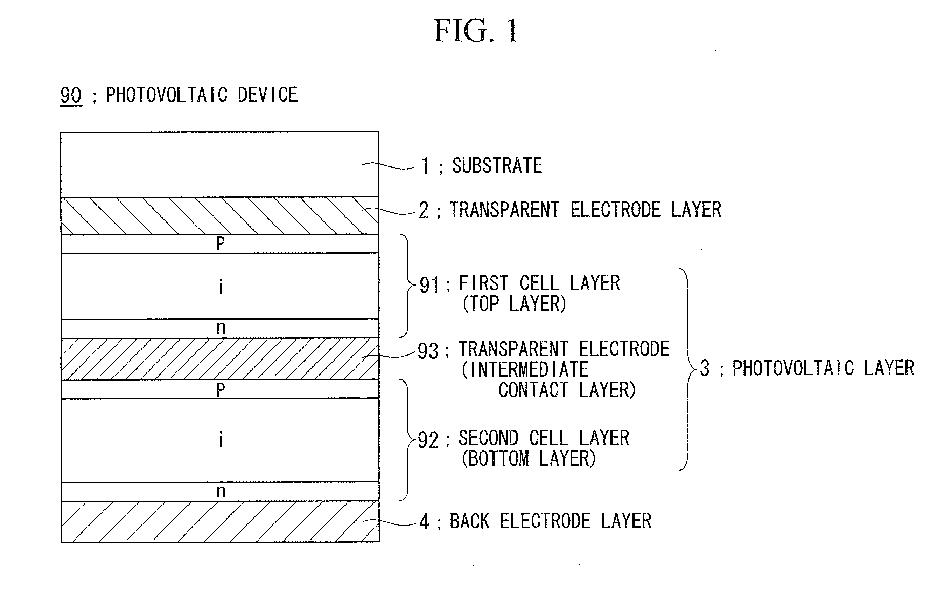

FIG. 1 is a schematic view showing the structure of a photovoltaic device according to this embodiment. The photovoltaic device 90 is a silicon-based solar cell, and comprises a substrate 1, a transparent electrode layer 2, a solar cell photovoltaic layer 3 comprising a first cell layer (a top layer ) 91 and a second cell layer (a bottom layer ) 92, and a back electrode layer 4. In this embodiment, the first cell layer 91 is a photovoltaic layer comprising mainly amorphous silicon-based semiconductors, and the second cell layer is a photovoltaic layer comprising mainly crystalline silicon-based semiconductors. The second cell layer 92 has a film thickness of not less than 1.2 $\mu$m and not more than 2.0 $\mu$m, and the Raman ratio for the second cell layer 92 is preferably not less than 3.0 and not more than 8.0. This Raman ratio is even more preferably not less than 3.5 and not more than 8.0, and is most preferably not less than 5.0 and not more than 7.5.

By ensuring that the Raman ratio for the second cell layer 92 is not less than 3.0 and not more than 8.0, a photovoltaic device can be obtained in which the crystal grain boundaries are suitably filled with amorphous silicon, meaning current leakage at the crystal grain boundaries can be suppressed, and as a result, a photovoltaic device can be obtained in which reductions in the open-circuit voltage (Voc) and the fill factor (FF) are suppressed.

Here, the term "Raman ratio" refers to a ratio determined by Raman spectroscopy between the crystalline Si intensity at 520 cm$^{-1}$ and the amorphous Si intensity at 480 cm$^{-1}$ (crystalline Si intensity / amorphous Si intensity) (this definition also applies below). In a method of measuring the Raman ratio, a test piece is prepared by removing the back electrode from the photovoltaic device using a solvent such as hydrogen peroxide. First, measuring light is irradiated onto the film surface of the second cell layer 92. A monochromatic laser can be used as the measuring light, and for example, the use of frequency-doubled YAG laser light (532 nm) is ideal. When the measuring light is irradiated onto the film surface of the second cell layer 92, Raman scattering is observed, and the measuring light and a portion of the scattered light is absorbed by the second cell layer 92. Accordingly, in the case where frequency-doubled YAG laser light is used as the measuring light, information can be obtained from the incident surface down to a depth of approximately 0.1 $\mu$m. In those cases where a second transparent electrode layer is formed between the second cell layer 92 and the back electrode layer 4, the Raman peak for the second transparent electrode layer can be subtracted as background, meaning the second transparent electrode layer need not necessarily be removed using a solvent such as dilute hydrochloric acid.

As described above, the Raman ratio evaluates the photovoltaic layer i-layer (the actual true layer), but with the laser wavelength of 532 nm that is typically used, the penetration depth of 0.1 $\mu$m means that the evaluation essentially amounts to an evaluation of the crystallization ratio of the film to a depth of approximately 0.1 $\mu$m. In this embodiment, the description of the Raman ratio following formation of the i-layer of the second cell layer 92 being not less than 3.0 and not more than 8.0 represents a direct meaning, but even once the n-layer has been formed as the outermost layer, because the n-layer is very thin with a film thickness of approximately 0.03 $\mu$m, the information from the i-layer is still dominant, and because the crystallinity of the n-layer is typically within a range from 2 to 10, measurement of the Raman ratio including the n-layer following formation of the n-layer yields a similar result to that observed prior to formation of the n-layer. Accordingly, the Raman ratio for the second cell layer 92 is preferably within a range from not less than 3.0 to not more than 8.0.

Furthermore, the Raman ratio develops a distribution on the substrate 1 during film formation as a result of factors such as the structure of the film formation apparatus. For example, a localized Raman ratio distribution may develop during film formation as a result of variations in the raw material gas composition at the surface of the substrate 1, and an overall Raman ratio distribution may develop as a result of plasma and temperature distributions. Consequently, as far as possible, the Raman ratio is evaluated as an overall average value across the substrate 1. For example, in the case of a substrate size of 1 m square or greater, measurements are preferably conducted within 10 or more equally divided regions, and the average value of these measurements is then used for evaluation.

A Raman ratio of not less than 3.0 and not more than 8.0 generally indicates a structure that comprises a large quantity of amorphous silicon rather than a crystalline silicon in which crystallization has progressed significantly. Particularly in those cases where a high-haze substrate such as a double textured substrate is used, because crystal grain boundary defects occur as a result of the substrate texture, the grain boundaries must be suitably filled with an amorphous silicon. The reason that a Raman ratio of not less than 3.0 is preferred is that the Raman ratio required to ensure that the majority of the crystal structures extend in the direction of the film thickness, which enables electrical charge that develops within the crystalline silicon portions to be conducted through crystal structures that are linked in the cross-sectional direction, is not less than 3.0, and this can be confirmed by cross-sectional inspections. The reason that a Raman ratio of not more than 8.0 is preferred is that the crystal grain boundaries are preferably filled with an amorphous material in order to inhibit the grain boundaries of the columnar crystals from becoming current leakage points, which can prevent a voltage from developing, and testing reveals that the Raman ratio required to achieve this effect is 8.0 or less.

In this description, the term "silicon-based" is a generic term that includes silicon (Si), silicon carbide (SiC) and silicon-germanium (SiGe). Furthermore, the term "crystalline silicon-based" describes a silicon system other than an amorphous silicon system, and includes both microcrystalline silicon and polycrystalline silicon systems.

An intermediate contact layer 93 formed from a transparent electrode film may be provided between the first cell layer 91 and the second cell layer 92 (although the photovoltaic device of the present invention is not restricted to structures that include such an intermediate contact layer 93). In those cases where an intermediate contact layer 93 is provided, a portion of the sunlight incident upon the intermediate contact layer 93 is reflected and re-enters the first cell layer (the top layer) 91. As a result, the electric power generation current within the first cell layer (the top cell) 91 increases. Even if the film thickness of the first cell layer 91 is reduced, a similar electric power generation current to that achieved with no intermediate contact layer 93 can be obtained. Accordingly, by reducing the film thickness of the amorphous silicon-based semiconductors of the first cell layer 91, light degradation within the first cell layer 91 can be suppressed, enabling an improvement in the stabilization efficiency for the overall photovoltaic device.

By increasing the film thickness of the intermediate contact layer 93, the electric power generation current for the amorphous silicon-based semiconductors of the first cell layer 91 can be increased. This reduces the electric power generation current within the second cell layer 92 for the sunlight wavelengths reflected by the intermediate contact layer 93. In actual practice, the conversion of sunlight to electrical energy occurs at a longer wavelength region within the crystalline silicon-based semiconductors of the second cell layer 92 than within the amorphous silicon-based semiconductors of the first cell layer 91.

Accordingly, optimizing the film thickness of the intermediate contact layer 93 requires suppression of the absorption ratio for the intermediate contact layer 93 of sunlight within the long wavelength region, which should be absorbed by the crystalline silicon-based semiconductors of the second cell layer 92.

From the relationship between the film thickness of the intermediate contact layer 93 within the photovoltaic device according to this embodiment, and the quantum efficiency (the proportion of incident light that contributes to electric power generation) for light of wavelength 800 nm (corresponding with the long wavelength region of sunlight) within the second cell layer 92 it is evident that increasing the thickness of the intermediate contact layer 93 also increases the reflectance by the intermediate contact layer 93 of sunlight within the long wavelength region, reducing the quantity of light entering the second cell layer 92. The intermediate contact layer 93 preferably exhibits a light absorption within a range from $\lambda$ = 450 nm to 1,000 nm that is less than 1%, and is preferably substantially transparent to light in this wavelength region.

On the other hand, increasing the thickness of the intermediate contact layer 93 improves the light containment effect between the intermediate contact layer 93 and the back electrode layer 4. As a result, the absorption of incident light entering the second cell layer 92 increases. For sunlight with a wavelength of 800 nm, a film thickness for the intermediate contact layer 93 that ensures an efficient light containment effect within the second cell layer 92 (wherein the quantum efficiency can be maintained at a constant value) is 100 nm or less.

As described above, in consideration of the balance between the electric power generation currents within the first cell layer 91 and the second cell layer 92, an ideal film thickness for the intermediate contact layer 93, determined by testing, is typically not more than 90 nm, and is preferably not less than 50 nm and not more than 70 nm. Employing such a film thickness enables a photovoltaic device with a higher degree of stabilization efficiency to be achieved.

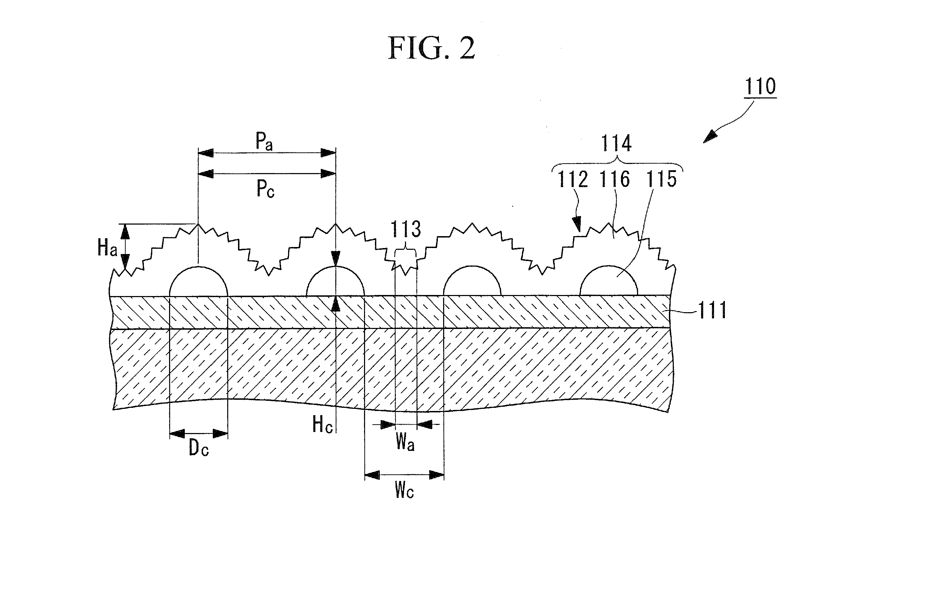

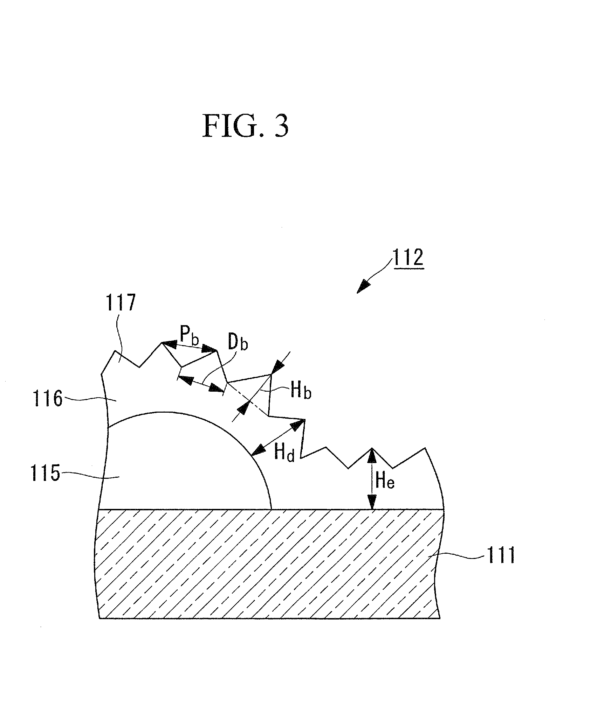

Next, the shape and structure of a transparent, electrically insulating substrate with a transparent electrode formed thereon (hereafter also referred to as the "transparent electrode-bearing substrate"), which is used within the photovoltaic device according to the first embodiment of the present invention, is described below in detail with reference to FIG. 2 and FIG. 3, although the photovoltaic device of the present invention and the process for producing such a device are not limited by these figures.

FIG. 2 is a partially cut-away cross-sectional view showing the shape and structure of a transparent electrode-bearing substrate used in this embodiment, and FIG. 3 is an enlarged view of a ridge 112 shown in FIG. 2. As shown in FIG. 2, the transparent electrode-bearing substrate 110 used in this embodiment has a structure comprising macro-roughness (texture) formed from a plurality of discontinuous ridges 112 and a plurality of flat portions 113 that fill the regions between the ridges formed on top of a glass substrate 111, wherein the outer surfaces of the ridges 112 and the flat portions 113 contain a multitude of micro-roughness irregularities (texture). In the following description, a structure having these two types of textures is referred to as a double textured structure.

Furthermore, in this embodiment, as shown in FIG. 2, a transparent electrode 114 preferably comprises a discontinuous small ridge 115 formed from a first oxide, and a continuous layer 116, which is formed on top of the small ridge 115 using a second oxide and includes a multitude of continuous micro-protrusions within the surface of the continuous layer. The density of the small ridges 115 within a 10 $\mu$m square area of the surface of the substrate 111 is typically not less than 15 and not more than 50, and is preferably not less than 20 and not more than 45. The average pitch $P_c$ between these small ridges 115 is not less than 1.0 $\mu$m and not more than 3 $\mu$m. The continuous layer 116 formed from the second oxide is formed in a continuous manner on top of the small ridges 115 and those portions of the glass substrate 111 where the small ridges 115 have not been formed.

In this embodiment, the average height $H_a$ of the above ridges 112 (the average value of the height measured from the apex of a micro-protrusion within the flat portion) is typically not less than 0.4 $\mu$m and not more than 0.7 $\mu$m, and is preferably not less than 0.5 $\mu$m and not more than 0.6 $\mu$m.

Furthermore, the average distance of a flat portion between adjacent ridges (hereafter also described as simply "the spacing between ridges") $W_a$, along a straight line, is preferably not less than 0 $\mu$m and not more than 1.5 $\mu$m, is even

more preferably not less than 0 $\mu$m and not more than 1.0 $\mu$m, and is most preferably not less than 0.1 $\mu$m and not more than 0.4 $\mu$m (meaning all the ridges 112 are discontinuous). In this embodiment, the plurality of ridges 112 may include discontinuous portions and continuous portions, and the specifying of the spacing between ridges $W_a$ as being not less than 0 $\mu$m and not more than 1.5 $\mu$m means locations may exist in which there are no flat portions. When a flat portion does not exist, the value of $H_a$ can be measured using a nearby flat portion even if the flat portion is not adjacent to the ridge, or alternatively, the value of $H_a$ can be measured by examination of a cross-section of the structure under a microscope.

Moreover, the density of the ridges 112 is the same as the density of the small ridges 115, namely a density of not less than 15 and not more than 50, and preferably not less than 20 and not more than 45, within a 10 $\mu$m square area of the surface of the substrate 111. The average pitch $P_a$ between these ridges 112 is not less than 1.0 $\mu$m and not more than 3 $\mu$m.

In this embodiment, the height $H_c$ of the above small ridges 115 is the same as the above height $H_a$ of the ridges, namely not less than 0.4 $\mu$m and not more than 0.7 $\mu$m, and preferably not less than 0.5 $\mu$m and not more than 0.6 $\mu$m.

In this embodiment, the surfaces of the ridges 112 and the flat portions 113, namely the surface of the continuous layer 116 formed from the second oxide, has a multitude of micro-protrusions 117, as shown in FIG. 3. The base diameter of this multitude of micro-protrusions is not less than 0.1 $\mu$m and not more than 0.3 $\mu$m, and the ratio of height/base diameter is not less than 0.7 and not more than 1.2. The continuous layer of micro-protrusions is shown with the micro-protrusions existing across the entire surface, and even if a region exists in which the micro-protrusions are partially absent, the micro-protrusions are still deemed to be continuous.

Furthermore, as shown in FIG. 3, the thickness $H_d$ of the continuous layer 116 (including the micro-protrusions) on top of the small ridge 115 is preferably not less than 0.5 $\mu$m and not more than 1.0 $\mu$m, and is even more preferably not less than 0.5 $\mu$m and not more than 0.7 $\mu$m. Similarly, the thickness He of the continuous layer 116 (including the micro-protrusions) on top of the glass substrate 111 is preferably not less than 0.5 $\mu$m and not more than 1.0 $\mu$m, and is even more preferably not less than 0.5 $\mu$m and not more than 0.7 $\mu$m.

In this embodiment, by covering the exterior surface of the ridges 112 and flat portions 113 with a fine texture (micro-texture) that is smaller than the texture (macro-texture) provided by the ridges, short wavelength light can be scattered more strongly, and overall, a broader region of light is able to effectively scattered. In other words, because long wavelength light can be scattered by the ridges that function as the macro-texture, and short wavelength light can be scattered by the micro-textured surface, a high overall level of light scattering performance can be achieved.

In this embodiment in particular, by controlling the height and density of the ridges 112, the scattering of long wavelength light is optimized, enabling an improvement in the electric power generation efficiency of the photovoltaic layer comprising mainly crystalline silicon-based semiconductors, and a shortening of the film formation time.

The above type of surface state on the transparent electrode-bearing substrate 110 can be confirmed, for example, using the methods described below.

(1) Surface Shape Analysis: The protrusions on the film surface are inspected using a scanning electron microscope (SEM), and the base diameter of the protrusions can be measured from the resulting microscope photograph. Furthermore, the shape of the texture at the film surface is inspected using a SEM and an atomic force microscope (AFM), and the texture shape and the height of the protrusions can be determined from the resulting microscope photographs.

(2) Measurement of Surface Coverage Ratio: The coverage of the substrate by the small ridges formed from the first oxide is measured from a SEM photograph, and the surface coverage ratio can then be evaluated as the area of the substrate occupied by the small ridges divided by the total covered surface area of the substrate.

Furthermore, the mass film thickness refers to a film thickness value obtained by analyzing the discontinuous metal oxide within a fixed area on top of the substrate, by using a fluorescent X-ray apparatus to measure a detection quantity that is proportional to the metal quantity within the metal oxide, comparing this detected quantity with the fluorescent X-ray detection quantity for separately prepared substrates in which the same metal oxide has been formed in a continuous manner and with a known film thickness, and then estimating the film thickness under the assumption that the volume of discontinuous oxide is actually continuous.

Furthermore, a transparent electrode-bearing substrate 110 with this type of shape and structure exhibits a spectral haze ratio for wavelengths of not less than 550 nm and not more than 800 nm which, for the entire substrate, is not less than 30%, and is preferably 40% or greater.

Here, the "spectral haze ratio" defines the proportion of the scattered component within the transmitted light. The spectral haze ratio is dependent on the wavelength, and if the spectral haze ratio is termed $Hz(\lambda)$, the total transmittance is termed $T_{total}(\lambda)$, the direct component of the transmitted light is termed $T_{direct}(\lambda)$, and the scattered component of the transmitted light is termed $T_{diffuse}(\lambda)$, then the relationships represented by the following equations are valid.

$$T_{total}(\lambda) = T_{direct}(\lambda) + T_{diffuse}(\lambda)$$

$$Hz(\lambda) = T_{diffuse}(\lambda) / T_{total}(\lambda) \times 100 \ (\%)$$

Substrates (transparent substrates), first oxides and second oxides that satisfy the shape, structure and properties of the aforementioned transparent electrode-bearing substrate of this embodiment are described below in detail.

<Substrate (Transparent Substrate)>

The substrate used in the transparent electrode-bearing substrate of this embodiment need not necessarily be a flat sheet, and curved surfaces or irregular shapes are also possible.

At least the surface of this substrate is preferably formed from a different material from the first oxide described below, and specific examples of suitable substrates include glass substrates, ceramic substrates, plastic substrates and metal substrates, as well as substrates in which the surfaces of the above substrates have been coated with an alkali barrier layer such as a silicon oxide film, aluminum oxide film, zirconium oxide film or titanium oxide film. Of these possibilities, a transparent substrate with excellent transparency is preferred, and a glass substrate or an alkali barrier layer-coated glass substrate is preferred in terms of strength and heat resistance.

Furthermore, these substrates preferably exhibit a high transmittance, for example a transmittance of not less than 80%, for the wavelength region from not less than 550 nm to not more than 800 nm, which represents the main absorption wavelength region for the photovoltaic layer, and preferably also exhibit satisfactory insulation properties, and high levels of chemical and physical durability.

Examples of the above glass substrates include transparent glass sheets formed from colorless and transparent soda-lime silicate glass, aluminosilicate glass, borate glass, lithium aluminosilicate glass, quartz glass, borosilicate glass sheets, alkali-free glass sheets, and various other glasses.

Furthermore, in those cases where the transparent electrode-bearing substrate of this embodiment is used as the substrate for a solar cell, a glass substrate with a thickness of not less than 0.2 mm and not more than 6.0 mm is preferred in terms of strength and transmittance.

In the case of a glass substrates formed from a glass that contains sodium, such as soda-lime silicate glass, or a glass substrate formed from a low-alkali glass, the glass substrate is preferably coated with an aforementioned alkali barrier layer in order to minimize diffusion of alkali components from the glass into the transparent electrode film formed on top of the glass.

Furthermore, a layer that reduces the difference in refractive index between the surface of the glass substrate and the layer provided on top of the substrate may also be provided on the surface of the glass substrate.

<First Oxide>

There are no particular restrictions on the first oxide used in forming the transparent electrode film of the transparent electrode-bearing substrate according to this embodiment, provided the oxide exhibits a high degree of transparency in the visible light region, and specific examples of suitable oxides include $TiO_2$, $SnO_2$, $In_2O_3$, $ZnO$, $CdO$, $CdIn_2O_4$, $CdSnO_3$, $MgIn_2O_4$, $CdGa_2O_4$, $GaInO_3$, $InGaZnO_4$, $Cd_2Sb_2O_7$ $Cd_2GeO_4$, $CuAlO_2$, $CuGaO_2$, $SrCu_2O_2$ and $Al_2O_3$. Of these, the use of at least one oxide selected from the group consisting of $TiO_2$ $SnO_2$ and fluorine-containing $SnO_2$ is preferred.

In this embodiment, the refractive index of the first oxide used for forming the small ridges is preferably not less than 1.8 and not more than 2.2, and even more preferably not less than 1.9 and not more than 2.1, for wavelengths of not less than 400 nm and not more than 800 nm.

One example of a method of forming the first oxide is described below. The alkali barrier layer-coated glass substrate described above is heated to 520˚C in a belt conveyor oven, and tin tetrachloride, water, and hydrogen chloride gas are then sprayed onto the glass substrate to form tin oxide nuclei. In this process, the tin tetrachloride and water are preheated and subjected to nitrogen gas bubbling, and are then transported at the same time as the hydrogen chloride gas and sprayed onto the substrate.

Following formation of the tin oxide nuclei, tin tetrachloride and water are sprayed simultaneously onto the glass substrate, thereby forming a first oxide film of $SnO_2$. In this process, the tin tetrachloride and water are preheated and subjected to nitrogen gas bubbling, before being transported and sprayed onto the glass substrate.

As described above, small ridges formed from this type of first oxide are discontinuous projections rather than a continuous film, and consequently those portions of the transparent substrate not covered by these projections naturally suffer zero loss in incident light absorption due to the small ridges, meaning the quantity of incident light entering the photovoltaic layer can be increased.

These small ridges increase the spectral haze ratio (raise the degree of light scattering) for long wavelength light, and in order to inhibit the absorption of free electrons and ensure a high degree of transparency, preferably have no electrical conductivity. Accordingly, in those cases where $SnO_2$ is used as the first oxide, the small ridges are preferably formed solely from $SnO_2$, or even in the case where the $SnO_2$ contains fluorine, the fluorine content relative to the $SnO_2$ is preferably not more than 0.01 mol%, and is even more preferably 0.005 mol% or less.

<Second Oxide>

The second oxide used in forming the transparent electrode film of the transparent electrode-bearing substrate according to his embodiment must be transparent within the visible light region and must be a transparent conductive oxide that exhibits conductivity. Specific examples of suitable oxides include $SnO_2$, ZnO and $In_2O_3$, two or more of which may be combined, and the oxide preferably includes a dopant to ensure manifestation of the required conductivity.

Of these possibilities, $SnO_2$ preferably contains fluorine or antimony as the dopant, in a quantity of not less than 0.01 mol% and not more than 4 mol% relative to the $SnO_2$. ZnO preferably contains at least one dopant selected from the group consisting of boron, Al and Ga as the dopant, in a quantity of not less than 0.02 mol% and not more than 5 mol% relative to the $SnO_2$. $In_2O_3$ preferably contains Sn as the dopant, in a quantity of not less than 0.02 mol% and not more than 4 mol% relative to the $In_2O_3$. Doping with these dopants may be conducted using hydrogen halides. Specific examples of these types of hydrogen halides include HF and HBr and the like.

In this embodiment, the refractive index of this type of second oxide used for forming a continuous layer is preferably not less than 1.8 and not more than 2.2, and even more preferably not less than 1.9 and not more than 2.1, for wavelengths of not less than 400 nm and not more than 800 nm.

Furthermore, using a $SnO_2$ containing fluorine as the above second oxide increases the conductive electron density. A substrate for use in a solar cell preferably has a conductive electron density that is not less than $5 \times 10^{19}$ $cm^{-3}$ and not more than $4 \times 10^{20}$ $cm^{-3}$, and even more preferably not less than $1 \times 10^{20}$ $cm^{-3}$ and not more than $2 \times 10^{20}$ $cm^{-3}$. Provided the conductive electron density is within this range, the continuous layer formed from the second oxide exhibits minimal light absorption, a high degree of transparency, and a high degree of durability to active hydrogen species, meaning the transparency is not lost during the hydrogen plasma irradiation commonly used during formation of thin-film silicon-based solar cells.

The first oxide and second oxide described above may use the same oxide, and in this embodiment, the use of $SnO_2$ for both oxides is preferred. Furthermore, the refractive indices for the oxide layers of the first oxide and second oxide are preferably substantially equal, and specifically, are preferably not less than 1.8 and not more than 2.2. Provided the refractive indices for both the first oxide and the second oxide fall within this range, light reflection at the interface between the first oxide and second oxide is controlled, and the transmittance does not decrease, which is desirable.

Furthermore, in this embodiment, an oxide layer formed from an oxide with a different composition from the first and second oxides (hereafter also referred to as simply the "different oxide layer") is preferably formed between the small ridges formed from the above first oxide and the continuous layer formed from the second oxide. Including this type of different oxide layer facilitates the formation of the multitude of micro-protrusions on the surface of the continuous layer formed from the second oxide, enabling ready formation of the structure comprising ridges and flat portions.

Furthermore, in a transparent electrode film with this type of multilayer structure comprising a different oxide layer, the reflection at the interfaces between the respective layers must be reduced in order to maximize the quantity of incident light entering the photovoltaic layer described below. In other words, reflection at each of the interfaces between the glass substrate, the ridges formed from the first oxide, the different oxide layer and the continuous layer formed from the second oxide is preferably reduced as much as possible. In order to achieve this effect, the refractive indices for the first oxide, the different oxide layer and the second oxide are preferably as similar as possible, and if the refractive indices do vary, then the thickness of the different oxide layer is preferably as thin as possible.

Examples of this type of different oxide layer include oxides of one or more elements selected from the group consisting of Si, Sn, Al, Zr and Ti, and of these, the layer preferably comprises an oxide of Si as the main component. Furthermore, because the other oxide layer requires a high level of transmittance, amorphous $SiO_2$ is particularly desirable.

The film thickness of the different oxide layer is preferably not less than 2 nm and not more than 40 nm, and is even more preferably not less than 10 nm and not more than 30 nm.

As described above, the transparent electrode-bearing substrate of this embodiment comprises a plurality of ridges and a plurality of flat portions that fill the regions between the ridges, and the surfaces of these ridges and flat sections contain a multitude of continuous micro-protrusions. The height from the substrate to the apex of a ridge (including the micro-protrusions) is preferably not less than 0.8 $\mu$m and not more than 3.0 $\mu$m, and is even more preferably not less than 0.8 $\mu$m and not more than 1.0 $\mu$m. The base diameter of the multitude of micro-protrusions is typically not less than 0.1 $\mu$m and not more than 0.3 $\mu$m, and the ratio of height/base diameter is preferably not less than 0.7 and not more than 1.2. Furthermore, the sheet resistance of the entire film is preferably not less than 8 $\Omega$/squire and not more than 20 $\Omega$/square, and is even more preferably not less than 8 $\Omega$/square and not more than 12 $\Omega$/square, whereas the transmittance (transparency) at 550 nm, measured using a liquid immersion method, is preferably not less than 80% and not more than 90%, and is even more preferably not less than 85% and not more than 90%.

Furthermore, when a transparent electrode-bearing substrate of this embodiment with the structure described above is used as the transparent electrode of a photovoltaic device, incident light entering through the substrate is refracted and scattered by the transparent electrode, enters a photovoltaic conversion section, and then travels over a long distance within the photovoltaic conversion section. As a result, a large quantity of the light is absorbed by the photovoltaic conversion section, enabling an improvement in the photovoltaic conversion efficiency. Particularly when used within a solar cell, the short-circuit current can be maintained at a high level with no reduction in the open-circuit voltage or the fill factor, thereby improving the photovoltaic conversion efficiency.

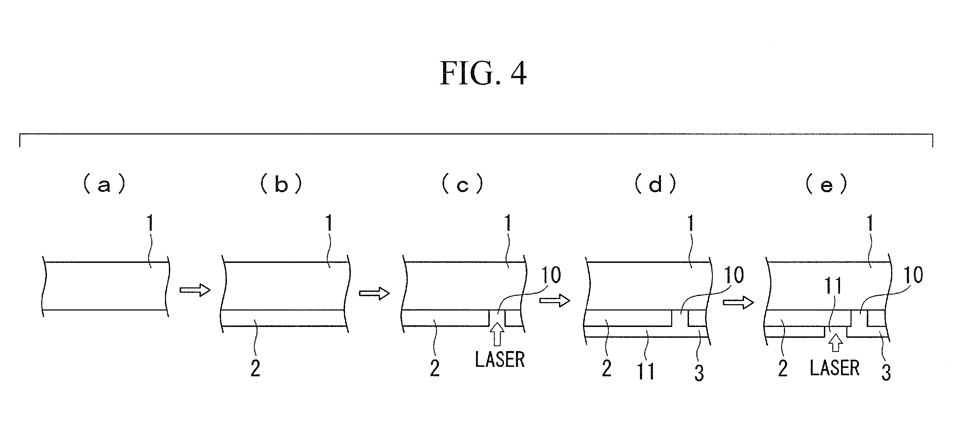

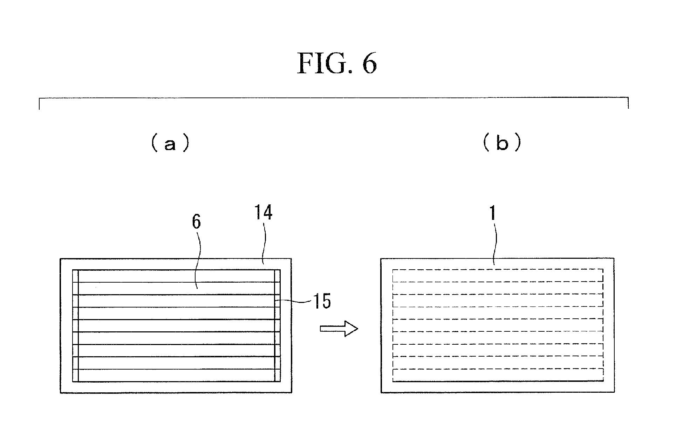

Next is a description of a process for producing a solar cell panel according to the present embodiment. The description focuses on an example in which a photovoltaic layer comprising mainly amorphous silicon-based semiconductors and a photovoltaic layer comprising mainly crystalline silicon-based semiconductors are deposited sequentially, as solar cell photovoltaic layers 3, on top of a glass substrate that functions as a substrate 1. FIG. 4 through FIG. 7 are schematic views showing the process for producing a solar cell panel according to this embodiment.

(1) FIG. 4(a)

A soda float glass substrate (1.4 m $\times$ 1.1 m $\times$ thickness: 4 mm) is used as the substrate 1. The edges of the substrate are preferably subjected to corner chamfering or R-face chamfering to prevent damage.

(2) FIG. 4(b)

Based on the embodiment described above, a transparent electrode layer 2 is formed on top of the substrate 1, thereby forming a transparent electrode-bearing substrate. In addition to the transparent electrode film, the transparent electrode layer 2 may include an alkali barrier film (not shown in the figure) formed between the substrate 1 and the transparent electrode film. The alkali barrier film is formed by using a heated CVD apparatus to form a silicon oxide film ($SiO_2$) of not less than 50 nm and not more than 150 nm at a temperature of approximately 500˚C.

(3) FIG. 4(c)

Subsequently, the substrate 1 is mounted on an X-Y table, and the first harmonic of a YAG laser (1064 nm) is irradiated onto the film surface of the transparent electrode film, as shown by the arrow in the figure. The laser power is adjusted to ensure an appropriate process speed, and the transparent electrode film is then moved in a direction perpendicular to the direction of the series connection of the electric power generation cells 5, thereby causing a relative movement of the substrate 1 and the laser light, and conducting laser etching across a strip with a width of not more than approximately 6 mm and not more than 12 mm to form a slot 10.

(4) FIG. 4(d)

Using a plasma CVD apparatus under conditions including a reduced pressure atmosphere of not less than 30 Pa and not more than 150 Pa, a substrate temperature of approximately 200˚C, and a plasma RF generation frequency of not less than 13 MHz and not more than 100 MHz, a p-layer, i-layer and n-layer each formed from a thin film of amorphous silicon are formed sequentially as the first cell layer (the top layer ) 91 of a photovoltaic layer 3. The first cell layer 91 is formed on top of the transparent electrode layer 2 using $SiH_4$ gas and $H_2$ gas as the main raw materials. The p-layer, i-layer and n-layer are deposited in this order, with the p-layer closest to the surface from which incident sunlight enters.

In this embodiment, the p-layer of the first cell layer 91 is preferably an amorphous B-doped SiC film generated by reaction of $SiH_4$, $H_2$, $CH_4$ and $B_2H_6$ gas using an RF plasma, and the film thickness is preferably not less than 4 nm and not more than 16 nm. The i-layer of the first cell layer 91 is preferably an amorphous Si film generated by reaction of $SiH_4$ and $H_2$ using an RF plasma, and the film thickness is preferably not less than 100 nm and not more than 400 nm. The n-layer of the first cell layer 91 is preferably a Si film containing a crystalline component, generated by reaction of $SiH_4$, $H_2$, and $PH_3$ gas using an RF plasma, wherein the Raman ratio of the lone n-layer film is not less than 2, and the film thickness is preferably not less than 10 nm and not more than 80 nm. The "Raman ratio" refers to the ratio determined by Raman spectroscopy between the crystalline Si intensity at 520 cm$^{-1}$ and the amorphous Si intensity at

480 cm$^{-1}$ (crystalline Si intensity / amorphous Si intensity) (this definition also applies below). Furthermore, in order to suppress band mismatch at the interface between the p-layer (SiC film) and the i-layer (Si film), a substance with an intermediate band gap may be inserted as a buffer layer (not shown in the figure).

Next, using a plasma CVD apparatus under conditions including a reduced pressure atmosphere of not more than 3 kPa, a substrate temperature of approximately 200˚C, and a plasma RF generation frequency of not less than 40 MHz and not more than 200 MHz, a microcrystalline p-layer, microcrystalline i-layer and microcrystalline n-layer each formed from a thin film of microcrystalline silicon are formed sequentially, as the second cell layer (the bottom layer ) 92, on top of the first cell layer 91.

In this embodiment, the p-layer of the second cell layer 92 is preferably a Si film containing a crystalline component, generated by reaction of $SiH_4$, $H_2$, and $B_2H_6$ gas using an RF plasma, wherein the Raman ratio of the lone p-layer film is not less than 2, and the film thickness is preferably not less than 10 nm and not more than 60 nm. The i-layer of the second cell layer 92 is preferably a Si film containing a crystalline component, generated by reaction of $SiH_4$ and $H_2$ using an RF plasma, wherein the Raman ratio when the i-layer is deposited with a film thickness of 1.5 $\mu$m is not less than 3.0 and not more than 8.0, and the film thickness is preferably not less than 1,200 nm and not more than 2,000 nm. The Raman ratio is even more preferably not less than 3.5 and not more than 8.0, and is most preferably not less than 5.0 and not more than 8.0. The lower limit for the Raman ratio of not less than 3.0 is determined as the Raman ratio required to ensure that the majority of the crystal structures extend in the direction of the film thickness, which enables electrical charge that develops within the crystalline silicon portions to be conducted through crystal structures that are linked in the cross-sectional direction, and this can be confirmed by cross-sectional inspections. In terms of the upper limit for the Raman ratio, the crystal grain boundaries are preferably filled with an amorphous material in order to inhibit the grain boundaries of the columnar crystals from becoming current leakage points, which can prevent a voltage from developing, and the Raman ratio required to achieve this effect can be determined by testing as 8.0 or less.

The n-layer of the second cell layer 92 is preferably a Si film containing a crystalline component, generated by reaction of $SiH_4$, $H_2$, and $PH_3$ gas using an RF plasma, wherein the Raman ratio of the lone n-layer film is not less than 2, and the film thickness is preferably not less than 10 nm and not more than 80 nm.

During formation of the microcrystalline silicon thin films and particularly the microcrystalline i-layer by plasma CVD, the distance d between the plasma discharge electrode and the surface of the substrate 1 is preferably not less than 3 mm and not more than 10 mm. If this distance is less than 3 mm, then the precision of the various structural components within the film formation chamber required for processing large substrates means that maintaining the distance d at a constant level becomes difficult, which increases the possibility of the electrode getting too close and making the discharge unstable. If the distance exceeds 10 mm, then achieving a satisfactory film formation rate (of not less than 1 nm/s) becomes difficult, and the uniformity of the plasma also deteriorates, causing a deterioration in the quality of the film due to ion impact. The i-layer of the second cell layer 92 is preferably formed under conditions including an RF frequency of not less than 40 MHz and not more than 200 MHz, a gas pressure of not less than 0.5 kPa and not more than 3 kPa, and a film formation rate of not less than 1 nm/s and not more than 3 nm/s, and in this embodiment, film formation is conducted using an RF frequency of 60 MHz, a gas pressure of 1.6 kPa, and a film formation rate of 2 nm/s.

With the objective of forming a semi-reflective film to achieve electrical current consistency between the first cell layer 91 and the second cell layer 92, a ZnO-based film (such as a GZO (Ga-doped ZnO) film) with a film thickness of not less than 0 nm and not more than 90 nm may be formed as an intermediate contact layer 93 using a sputtering apparatus. In this intermediate contact layer 93, the light absorption for the lone ZnO film within a range from $\lambda$ = 450 nm to 1,000 nm is preferably less than 1%.

(5) FIG. 4(e)

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to not less than 10 kHz and not more than 20 kHz, the laser power is adjusted so as to achieve a suitable process speed, and laser etching is conducted at a target not less than approximately 100 $\mu$m and not more than 150 $\mu$m to the side of the laser etching line within the transparent electrode layer 2, so as to form a slot 11. Provided the positions of the laser etching lines are not inverted, no particular problems arise, but in consideration of positioning tolerances, the target is preferably set to a numerical value listed above.

(6) FIG. 5(a)

Using a sputtering apparatus, a Ag film is then formed as the back electrode layer 4 under a reduced pressure atmosphere and at a temperature of approximately 150˚C. In this embodiment, the Ag film of the back electrode layer 4 is formed with a film thickness of not less than 150 nm, and in order reduce the contact resistance between the n-layer and the back electrode layer 4 and improve the reflectance, a ZnO-based film (such as a GZO (Ga-doped ZnO) film) with a film thickness of not less than 10 nm is formed between the photovoltaic layer 3 and the back electrode layer 4 using a sputtering apparatus.

(7) FIG. 5(b)

The substrate 1 is mounted on an X-Y table, and the second harmonic of a laser diode excited YAG laser (532 nm) is irradiated onto the substrate 1, as shown by the arrow in the figure. The laser light is absorbed by the photovoltaic layer 3, and by using the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a target not less than approximately 250 $\mu$m and not more than 400 $\mu$m to the side of the laser etching line within the transparent electrode layer 2, so as to form a slot 12. Provided the positions of the laser etching lines are not inverted, no particular problems arise, but in consideration of positioning tolerances, the target is preferably set to a numerical value listed above.

(8) FIG. 5(c)

The electric power generation regions are compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated onto the substrate 1. The laser light is absorbed by the transparent electrode layer 2 and the photovoltaic layer 3, and by using the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point not less than approximately 5 mm and not more than 15 mm from the edge of the substrate 1, so as to form an X-direction insulation slot 15. A Y-direction insulation slot need not be provided at this point, because a film surface polishing and removal treatment is conducted on the peripheral regions of the substrate 1 in a later step.
Conducting the etching at a position not less than approximately 5 mm and not more than 10 mm from the edge of the substrate 1 is preferred, as it ensures that the insulation slot 15 is effective in inhibiting external moisture from entering the interior of the solar cell module 6 via the edges of the solar cell panel.

(9) FIG. 6(a)

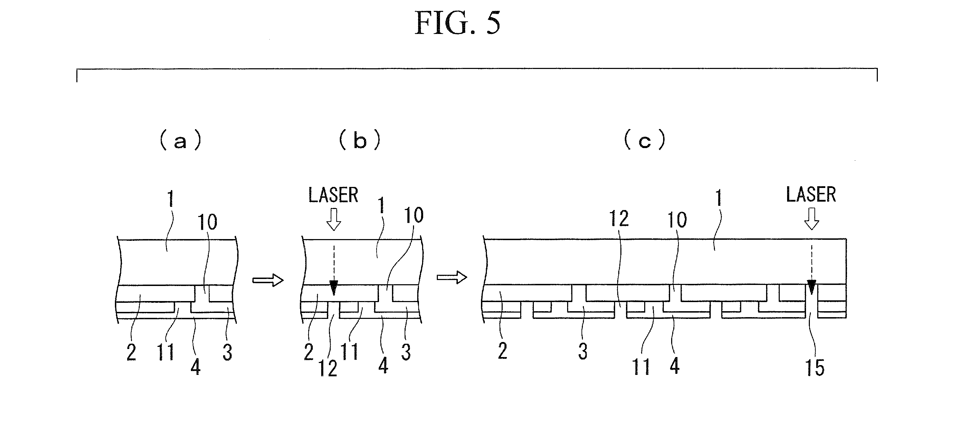

In order to ensure favorable adhesion and sealing of a backing sheet via EVA or the like in a subsequent step, the deposited films around the periphery of the substrate 1 (in the peripheral region 14) are removed, as they tend to be uneven and prone to peeling. First, grinding or blast polishing or the like is conducted to remove the back electrode layer 4, the photovoltaic layer 3, and the transparent electrode layer 2 from a region that is not less than 5 mm and not more than 20 mm from the edge of the substrate, and is closer to the substrate edge than the insulation slot 15 provided in the step of FIG. 5(c) described above. Grinding debris or abrasive grains are removed by washing the substrate 1.

(10) FIG. 6(b)

A terminal box attachment portion is prepared by providing an open through-window in the backing sheet and exposing a collecting plate. A plurality of layers of an insulating material are provided in the open through-window portion in order to prevent external moisture and the like entering the solar cell.
Processing is conducted so as to enable current collection, using a copper foil, from the series-connected solar cell electric power generation cell 5 at one end and the solar cell electric power generation cell 5 at the other end, and to enable electric power to be extracted from a terminal box portion on the rear surface of the solar cell panel. In order to prevent short circuits between the copper foil and the various portions, an insulating sheet that is wider than the width of the copper foil is provided.
Following arrangement of the collecting copper foil and the like at predetermined positions, the entire solar cell module 6 is covered, and a sheet of a filling material such as EVA (ethylene-vinyl acetate copolymer) is arranged so as not to protrude beyond the substrate 1.
A backing sheet 21 with a superior waterproofing effect is positioned on top of the EVA. In this embodiment, in order to achieve a superior waterproofing and moisture-proofing effect, the backing sheet 21 is formed as a three-layer structure comprising a PTE sheet, Al foil, and a PET sheet.
The structure comprising the components up to and including the backing sheet 21 arranged in predetermined positions is subjected to internal degassing under a reduced pressure atmosphere and pressing at approximately 150˚C using a laminator, thereby causing cross-linking of the EVA that tightly seals the structure.

(11) FIG. 7(a)

A terminal box is attached to the rear surface 24 of the solar cell module 6 using an adhesive.

(12) FIG. 7(b)

The copper foil and an output cable 23 from the terminal box are connected using solder or the like, and the interior of the terminal box is filled and sealed with a sealant (a potting material). This completes the production of the solar cell panel 50.

(13) FIG. 7(c)

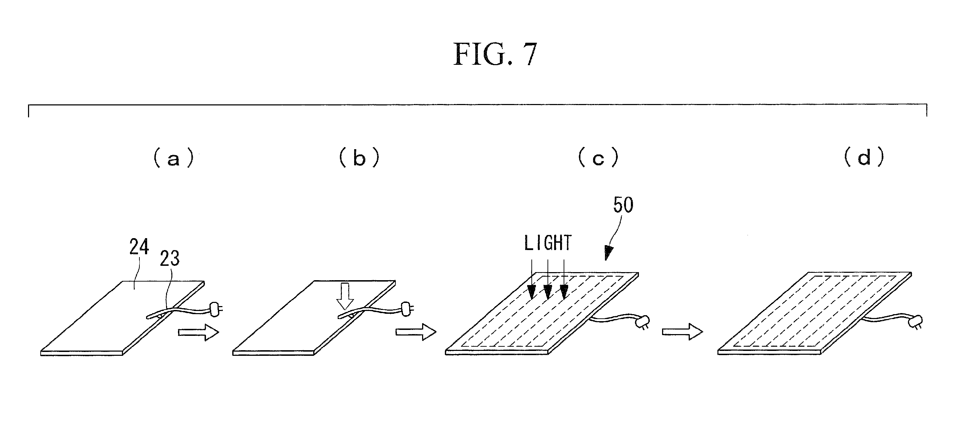

The solar cell panel 50 formed via the steps up to and including FIG. 7(b) is then subjected to an electric power generation test, as well as other tests for evaluating specific performance factors. The electric power generation test is conducted using a solar simulator that emits a standard sunlight of AM 1.5 (1,000 W/m$^2$).

(14) FIG. 7(d)

In tandem with the electric power generation test (FIG. 7(c)), a variety of specific performance factors including the external appearance are evaluated.
The aforementioned embodiment describes a solar cell using the example of a tandem solar cell having an amorphous silicon-based photovoltaic layer as the top cell and a crystalline (microcrystalline) silicon-based photovoltaic layer as the bottom cell, but the present invention is not limited to this example.
For example, the present invention can also be applied in a similar manner to other types of thin-film solar cells, including single solar cells containing only a crystalline silicon-based photovoltaic layer of microcrystalline silicon or the like, and multi-junction solar cells in which either one, or two or more, other photovoltaic layers are provided in addition to the top cell and bottom cell described above.

[Examples and Comparative Examples]

Comparative Example 1:

A single-layer textured structure containing a multitude of micro-roughness irregularities (texture), but in which macro-roughness (texture) comprising a plurality of discontinuous ridges was not formed, was used as the transparent electrode-bearing substrate. The base diameter of the multitude of micro-protrusions was from 0.2 to 0.3 $\mu$m, the height of the protrusions was from 0.1 to 0.2 $\mu$m, and the ratio of height/base diameter was from 0.7 to 1.0. The spectral haze ratio was 20% at a wavelength of 550 nm and 4% at a wavelength of 800 nm. With the exception of using a transparent electrode-bearing substrate with this single-layer textured structure, a tandem solar cell was produced in accordance with the embodiment of the present invention described above.
In terms of the various layers formed on the transparent electrode-bearing substrate, the top cell p-layer had a film thickness of 8 nm, the top cell n-layer had a film thickness of 40 nm, the bottom cell p-layer had a film thickness of 30 nm, the bottom cell n-layer had a film thickness of 30 nm, the ZnO layer of the back electrode had a film thickness of 80 nm, and the Ag layer of the back electrode had a film thickness of 300 nm, and these values were kept the same for each of the comparative examples and examples. The film thickness values for the top cell i-layer and the bottom cell i-layer for this example were as shown in Table 1, and an intermediate contact layer was not formed.
The cell performance of the obtained solar cell is shown in Table 2. The initial value for the electric power generation efficiency for the solar cell of this example, in which the film thickness of the bottom cell i-layer was set to 2 $\mu$m relative to a film thickness for the top cell i-layer of 300 nm, was 12.0%. The film thickness for the bottom cell i-layer takes into consideration the film thickness distribution within the solar cell region on top of the substrate, and is evaluated as a film thickness average value.
In Table 2, the evaluation items for the cell performance labeled Isc, Voc, FF, and Eff refer to the short-circuit electrical current, the open-circuit voltage, the fill factor, and the electric power generation efficiency (the initial value) respectively.
The (a-Si/c-Si) values for Isc refer to the Isc value for the a-Si (amorphous) top cell, and the Isc value for the c-Si (crystalline) bottom cell, determined from the spectral sensitivity. The tandem Isc is determined by the lower of the top cell Isc and the bottom cell Isc. In the examples and the comparative examples, the bottom cell is the determining factor, so that the bottom cell Isc becomes the tandem Isc. Furthermore, in the comparative examples and examples shown in Table 2, the results of the cell performance are recorded as relative values, with the results for the comparative example 1 set to 1. These results represent initial values prior to any degradation, but the rate of degradation is thought to be similar for the scope of these tests, meaning provided the results are presented as relative values, the values following degradation will be similar.

Comparative Example 2:

With the exceptions of forming the top cell i-layer, the intermediate contact layer and the bottom cell i-layer with the film thickness values shown in Table 1, a tandem solar cell was produced using the same method as the comparative example 1.

The cell performance of the obtained solar cell is shown in Table 2. The initial value for the electric power generation efficiency for the solar cell of this example, in which the film thickness of the bottom cell i-layer was set to 2 $\mu$m relative to a film thickness for the top cell i-layer of 250 nm and a film thickness for the ZnO intermediate contact layer of 50 nm, was 12.0%.

Comparative Example 3:

With the exceptions of forming the top cell i-layer and the bottom cell i-layer with the film thickness values shown in Table 1, a tandem solar cell was produced using the same method as the comparative example 1.

The cell performance of the obtained solar cell is shown in Table 2. The initial value for the electric power generation efficiency for the solar cell of this example, in which the film thickness of the bottom cell i-layer was set to 1.5 $\mu$m relative to a film thickness for the top cell i-layer of 300 nm, decreased to 10.8%. This decrease was due to a significant fall in the electric power generation current, and confirmed that for the substrate used in the comparative examples, the desired electrical current could not be obtained unless the film thickness of the bottom cell was at least 2 $\mu$m.

Example 1:

A tandem solar cell was produced in accordance with the embodiment of the present invention described above. A substrate with a double textured structure, prepared by depositing layers of $SnO_2$ containing discontinuous small ridges and a plurality of micro-protrusions, was used as the transparent electrode-bearing substrate (height of ridges: 500 nm, density of ridges: 30 per 10 $\mu$m square). The film thickness values for the top cell i-layer and the bottom cell i-layer in this example were as shown in Table 1, and an intermediate contact layer was not formed.

The cell performance of the obtained solar cell is shown in Table 2. The initial value for the electric power generation efficiency for the solar cell of this example, in which the film thickness of the bottom cell i-layer was set to 2 $\mu$m relative to a film thickness for the top cell i-layer of 300 nm, was able to be increased to 13.3%. This is an effect of having been able to considerably increase the electrical current of the bottom cell.

In the present invention, by using a transparent electrode with a double textured structure containing coarse roughness (macro-texture) provided by the ridges and a finer roughness (micro-texture), long wavelength light can be scattered by the ridges that function as the macro-texture, and short wavelength light can be scattered by the micro-textured surface.

As a result, the overall transparent electrode is able to achieve a high level of light scattering performance for light across a broad wavelength region. Furthermore, because of the presence of the macro-texture provided by the ridges, the shape of this macro-texture appears right through to the back electrode of the solar cell. As a result, reflected light from the back electrode is scattered effectively inside the solar cell, enabling a significant increase in the electrical current of the bottom cell.

Particularly in the present invention, because the height and density of the transparent electrode ridges are controlled and the film thickness of the solar cell layers is optimized, scattering of long wavelength light is optimized, enabling an improvement in the electric power generation efficiency of the photovoltaic layer comprising crystalline silicon-based semiconductors.

Example 2:

With the exceptions of forming the top cell i-layer and the bottom cell i-layer with the film thickness values shown in Table 1, a tandem solar cell of the example 2(1) was produced using the same method as the example 1.

The cell performance of the obtained solar cell is shown in Table 2. The initial value for the electric power generation efficiency for the solar cell of this example, in which the film thickness of the bottom cell i-layer was set to 1.5 $\mu$m relative to a film thickness for the top cell i-layer of 300 nm, was 12.8%, indicating that relative to the comparative example 1, an improvement in efficiency and a reduction in the film thickness of the bottom cell by 25% were able to be achieved simultaneously. By using the transparent electrode-bearing substrate according to this embodiment of the present invention, the same effect as that described for the example 1 enables a high electric power generation current to be achieved even when the thickness of the bottom cell is reduced, and because the film thickness of the bottom cell can be reduced, the Voc and FF values were able to be increased. Furthermore, by reducing the film thickness of the bottom cell i-layer, the production time for the photovoltaic device, which because of the thickness of the bottom cell i-layer is limited by the time taken to produce this i-layer, was able to be shortened significantly. Consequently, as a result of a synergistic effect with this faster film production, the productivity for the photovoltaic device is able to be improved.

Moreover, in order to investigate the dependency of the cell performance on the film thickness of the bottom cell i-layer, tandem solar cells of example 2(2) through example 2(5) were produced by altering the film thickness of the bottom cell i-layer of the example 2(1). The film thickness of the bottom cell i-layer in each of these examples is shown in Table 1. Furthermore, the solar cell performance for each example is shown in Table 2.

In the example 2, for bottom cell i-layer film thickness values within a range from not less than 1.2 $\mu$m to not more than 2.4 $\mu$m, efficiency results were obtained that were at least as favorable as those obtained in the comparative example 1 with a bottom cell i-layer film thickness of 2 $\mu$m. An even more preferred range for the film thickness of the bottom cell i-layer is from not less than 1.5 $\mu$m to not more than 2 $\mu$m.

Example 3:

With the exceptions of forming the top cell i-layer, the intermediate contact layer and the bottom cell i-layer with the film thickness values shown in Table 1, a tandem solar cell was produced using the same method as the example 2(1).

The cell performance of the obtained solar cell is shown in Table 2. The initial value for the electric power generation efficiency for the solar cell of this example, in which the film thickness of the bottom cell i-layer was set to 1.5 $\mu$m relative to a film thickness for the top cell i-layer of 250 nm and a film thickness for the ZnO intermediate contact layer of 50 nm, was 12.8%. Both an improvement in the efficiency and a reduction in the bottom cell film thickness were able to be achieved.

Example 4:

With the exception of altering the height of the ridges of the transparent electrode-bearing substrate to the values shown in Table 1, tandem solar cells of example 4(1) through example 4(5) were produced using the same method as the example 2(1), and the relationship between the ridge height and the cell performance was investigated. The cell performance of each the obtained solar cells is shown in Table 2. Ridge heights of not less than 0.4 $\mu$m and not more than 0.7 $\mu$m were appropriate. This is because a high electric power generation current is obtained for ridge heights of not less than 0.4 $\mu$m, whereas if the ridge height exceeds 0.7 $\mu$m, marked reductions in the Voc and FF values are observed.

Example 5:

With the exception of altering the density of the ridges on the transparent electrode-bearing substrate to the values shown in Table 1, tandem solar cells of example 5(1) through example 5(6) were produced using the same method as the example 2(1), and the relationship between the ridge density and the cell performance was investigated. The cell performance of each the obtained solar cells is shown in Table 2. When the density of the ridges within a 10 $\mu$m square was not less than 15 and not more than 50, efficiency results were obtained that were at least as favorable as those obtained in the comparative example 1 with an i-layer film thickness of 2 $\mu$m. An even more preferred range is from not less than 20 to not more than 45 ridges within a 10 $\mu$m square. If the density is too low, then Jsc (the current density) decreases, whereas if the density is too high, Jsc becomes saturated and Voc and FF fall, causing a reduction in the efficiency.

Table 1

| | Transparent electrode-bearing substrate ridges | Film thickness of top cell i-layer | Intermediate layer | Film thickness of bottom cell i-layer | Raman ratio following formation of bottom cell n-layer |
|---|---|---|---|---|---|
| Comparative example 1 | - | 300 nm | None | 2 $\mu$m | 6.5 |

(continued)

|  |  | Transparent electrode-bearing substrate ridges | Film thickness of top cell i-layer | Intermediate layer | Film thickness of bottom cell i-layer | Raman ratio following formation of bottom cell n-layer |
|---|---|---|---|---|---|---|
| Comparative example 2 |  | - | 250 nm | 50 nm | 2 $\mu$m | 6.5 |
| Comparative example 3 |  | - | 300 nm | None | 1.5 $\mu$m | 5.8 |
| Example 1 |  | Height: 0.5 $\mu$m, density: 30 | 300 nm | None | 2 $\mu$m | 6.5 |
| Example 2 | (1) | Height: 0.5 $\mu$m, density: 30 | 300nm | None | 1.5 $\mu$m | 5.8 |
|  | (2) |  | ↑ | ↑ | 1 $\mu$m | 5.0 |
|  | (3) |  | ↑ | ↑ | 1.2 $\mu$m | 5.4 |
|  | (4) |  | ↑ | ↑ | 1.7 $\mu$m | 6.2 |
|  | (5) |  | ↑ | ↑ | 2.4 $\mu$m | 6.8 |
| Example 3 |  | Height: 0.5 $\mu$m, density: 30 | 250 nm | 50 nm | 1.5 $\mu$m | 5.8 |
| Example 4 | (1) | Height: 0.4 $\mu$m, density: 30 | 300 nm | None | 1.5 $\mu$m | 5.8 |
|  | (2) | Height: 0.5 $\mu$m, density: 30 | ↑ | ↑ | ↑ | 5.8 |
|  | (3) | Height: 0.6 $\mu$m, density: 30 | ↑ | ↑ | ↑ | 5.8 |
|  | (4) | Height: 0.7 $\mu$m, density: 30 | ↑ | ↑ | ↑ | 5.8 |
|  | (5) | Height: 0.9 $\mu$m, density: 30 | ↑ | ↑ | ↑ | 5.8 |

(continued)

| | | Transparent electrode-bearing substrate ridges | Film thickness of top cell i-layer | Intermediate layer | Film thickness of bottom cell i-layer | Raman ratio following formation of bottom cell n-layer |
|---|---|---|---|---|---|---|
| Example 5 | (1) | Height: 0.5 $\mu$m, density: 10 | 300 nm | None | 1.5 $\mu$m | 5.8 |
| | (2) | Height: 0.5 $\mu$m, density: 15 | ↑ | ↑ | ↑ | 5.8 |
| | (3) | Height: 0.5 $\mu$m, density: 20 | ↑ | ↑ | ↑ | 5.8 |
| | (4) | Height: 0.5 $\mu$m, density: 30 | ↑ | ↑ | ↑ | 5.8 |
| | (5) | Height: 0.5 $\mu$m, density: 45 | ↑ | ↑ | ↑ | 5.8 |
| | (6) | Height: 0.5 $\mu$m, density: 50 | ↑ | ↑ | ↑ | 5.8 |

Table 2

| | | | Cell Performance | | | |
|---|---|---|---|---|---|---|
| | | | Isc (a-Si/c-Si) | Voc | FF | Eff |
| Comparative example 1 | | | 1 (1/1) | 1 | 1 | 1 |
| Comparative example 2 | | | 1 (1/1) | 1 | 1 | 1 |
| Comparative example 3 | | | 0.89 (1/0.89) | 1 | 1 | 0.89 |
| Example 1 | | | 1.15 (1/1.15) | 0.99 | 0.97 | 1.11 |
| Example 2 | (1) | | 1.06 (1/1.06) | 1.00 | 1.01 | 1.07 |
| | (2) | | 0.80 (1/0.80) | 1.02 | 1.04 | 0.86 |
| | (3) | | 0.96 (1/0.96) | 1.01 | 1.02 | 0.99 |
| | (4) | | 1.03 (1/1.03) | 0.99 | 1.01 | 1.03 |
| | (5) | | 1.13 (1/1.13) | 0.97 | 0.92 | 1.02 |
| Example 3 | | | 1.06 (1/1.06) | 1.00 | 1.01 | 1.07 |
| Example 4 | (1) | | 1.00 (1/1.00) | 1.01 | 1.01 | 1.02 |
| | (2) | | 1.06 (1/1.06) | 1.00 | 1.01 | 1.07 |
| | (3) | | 1.08 (1/1.08) | 0.99 | 0.99 | 1.06 |
| | (4) | | 1.10 (1/1.10) | 0.97 | 0.96 | 1.03 |
| | (5) | | 1.10 (1/1.10) | 0.92 | 0.88 | 0.90 |

(continued)

| | | Cell Performance | | | |
|---|---|---|---|---|---|
| | | Isc (a-Si/c-Si) | Voc | FF | Eff |
| Example 5 | (1) | 0.93 (0.9/0.9) | 1.00 | 0.99 | 0.92 |
| | (2) | 0.99 (1/0.99) | 1.00 | 1.00 | 0.99 |
| | (3) | 1.04 (1/1.04) | 1.00 | 1.01 | 1.05 |
| | (4) | 1.06 (1/1.06) | 1.00 | 1.01 | 1.07 |
| | (5) | 1.06 (1/1.06) | 0.98 | 0.98 | 1.02 |
| | (6) | 1.05 (1/1.06) | 0.97 | 0.96 | 0.98 |

Second Embodiment

A second embodiment of the present invention is described below.
In this embodiment, the transparent electrode-bearing substrate preferably comprises a mixture of coarse roughness and fine roughness, and this fine roughness (micro-texture) and coarse roughness (macro-texture) provides a mixed texture in which the pitch is from 0.1 $\mu$m to 1.2 $\mu$m, and the height is from 0.1 $\mu$m to 1.0 $\mu$m. Long wavelength light of 800 nm or greater can be diffused and contained by the macro-texture with a pitch of not less than 0.8 $\mu$m, whereas short wavelength light of 500 nm or less can also be effectively scattered and utilized by the micro-texture with a pitch of not more than 0.3 $\mu$m. In other words, because long wavelength light can be scattered by the macro-texture, and short wavelength light can be scattered by the micro-textured surface, a high overall level of light scattering performance can be achieved. Furthermore, the spectral haze ratio for wavelengths of not less than 550 nm and not more than 800 nm is 20% or greater.
In this embodiment, the transparent electrode-bearing substrate is the same as that used in the first embodiment, and within this transparent electrode-bearing substrate, the average height $H_a$ of the ridges 112 of the coarse roughness (the macro-texture) (namely, the average value of the height measured from the apex of a micro-protrusion within the flat portion) is typically not less than 0.4 $\mu$m and not more than 0.7 $\mu$m, and is preferably not less than 0.5 $\mu$m and not more than 0.6 $\mu$m. The density of the ridges is not less than 15 and not more than 50 within a 10 $\mu$m square area of the surface of the substrate 111, and the average pitch $P_a$ between these ridges is not less than 1.0 $\mu$m and not more than 3 $\mu$m. The base diameter of the multitude of micro-protrusions of the fine texture (micro-texture) is not less than 0.1 $\mu$m and not more than 0.3 $\mu$m, and the ratio of height/base diameter is not less than 0.7 and not more than 1.2.
This type of surface shape on the transparent electrode-bearing substrate can be confirmed, for example, by conducting the surface shape analyses described above for the first embodiment.
Furthermore, a transparent electrode-bearing substrate with this type of shape and structure exhibits a spectral haze ratio for wavelengths of not less than 550 nm and not more than 800 nm which, for the entire substrate, is not less than 20%, and is preferably 30% or greater.
Here, the definition of the "spectral haze ratio" is as described above within the first embodiment.
Substrates (transparent substrates) and oxides that satisfy the shape, structure and properties of the transparent electrode-bearing substrate of this embodiment are the same as the substrate and first oxide described above for the first embodiment, and consequently detailed description of these components is omitted from the following description.
The transparent electrode-bearing substrate of this embodiment preferably comprises a mixture of macro-texture and micro-texture, in which the pitch of the texture is from 0.1$\mu$ m to 1.2 $\mu$m, and the height is from 0.1 $\mu$m to 1.0 $\mu$m. Long wavelength light of 800 nm or greater can be diffused and contained by the macro-texture with a pitch of not less than 0.8 $\mu$m, whereas short wavelength light of 500 nm or less can also be effectively scattered and utilized by the micro-texture with a pitch of not more than 0.3 $\mu$m. Furthermore, the sheet resistance of the entire film is preferably not less than 8 $\Omega$/square and not more than 20 $\Omega$/square, and is even more preferably not less than 8 $\Omega$/square and not more than 12 $\Omega$/square, whereas the transmittance (transparency) at 550 nm, measured using a liquid immersion method, is preferably not less than 80% and not more than 90%, and is even more preferably not less than 85% and not more than 90%.
Furthermore, when a transparent electrode-bearing substrate of this embodiment is used as the transparent electrode of a photovoltaic device, incident light entering through the substrate is refracted and scattered by the transparent electrode, enters a photovoltaic conversion section, and then travels over a long distance within the photovoltaic conversion section. As a result, a large quantity of the light is absorbed by the photovoltaic conversion section, enabling an improvement in the photovoltaic conversion efficiency. Particularly when used within a solar cell, the short-circuit current can be maintained at a high level with no reduction in the open-circuit voltage or the fill factor, thereby improving the photovoltaic conversion efficiency.

With the exception of the provision of a hetero-phase-blocking layer or hetero-phase prevention layer described below, the structure of a photovoltaic device produced using a process for producing a photovoltaic device according to this embodiment, and a process for producing a solar cell according to this embodiment are the same as those described above for the first embodiment, and consequently reference is made to FIG. 1, and FIG. 4 through FIG. 7, which were used in the description of the first embodiment. Those members in common with the first embodiment are assigned the same reference symbols, and detailed descriptions of these members are omitted.

In a photovoltaic device of this embodiment, in order to block or prevent hetero-phases from penetrating through the first cell layer (the top layer) 91 formed from a photovoltaic layer comprising mainly amorphous silicon-based semiconductors, from the surface on the transparent electrode layer side through to the surface on the back electrode layer side, a method shown in the following embodiment of a process for producing a photovoltaic device is used to either provide a hetero-phase-blocking layer (not shown in the figures) within the first cell layer (the top layer) 91, or provide a hetero-phase prevention layer (not shown in the figures) between the substrate 1 and the first cell layer (the top layer) 91. An intermediate contact layer 93 formed from a transparent electrode film may also be provided between the first cell layer (the top layer) 91, and the second cell layer (the bottom layer) 92 formed from a photovoltaic layer comprising mainly crystalline silicon-based semiconductors (although the photovoltaic device of the present invention is not limited to structures containing such an intermediate contact layer 93).

In a process for producing a solar cell panel according to the present embodiment, first, the same methods as those shown in FIG. 4(a) and FIG. 4(b) of the first embodiment are conducted, thereby forming a transparent electrode substrate.

Next, a hetero-phase prevention layer of this embodiment can be formed by subjecting the surface of the formed transparent electrode layer 2 to an ion treatment. This ion treatment involves, for example, conducting ion etching by the irradiation of argon ions within a vacuum. An example of the apparatus used for the ion treatment is an ion milling apparatus that uses a filament type ion source. When the ion treatment is conducted using this apparatus, the chamber is evacuated to a vacuum in the order of $10^{-4}$ Pa, argon gas is supplied to the chamber, Ar ions are generated under conditions at $5 \times 10^{-3}$ Pa, and ion irradiation is then conducted at an accelerating voltage of 1 kV to effect the ion treatment. The ions are preferably irradiated perpendicularly onto the surface of the transparent electrode layer 2 of the transparent electrode-bearing substrate. The irradiation time can typically be set to approximately 180 seconds.

The same method as that shown in FIG. 4(c) of the first embodiment is then used to perform laser etching of the transparent electrode film, and with the exception of the subsequent provision of a hetero-phase-blocking layer or hetero-phase prevention layer, the same method as that shown in FIG. 4(d) is then used to form a photovoltaic layer 3. A p-layer, i-layer and n-layer each formed from a thin film of amorphous silicon are formed sequentially as the first cell layer (the top layer ) 91 of the photovoltaic layer 3. The p-layer, i-layer and n-layer are deposited in this order, with the p-layer closest to the surface from which incident sunlight enters.

Prior to formation of the first cell layer 91, placement of the transparent electrode-bearing substrate in a vacuum chamber at a pressure of not more than $10^{-1}$ Pa, followed by preheating (baking) of the substrate with a heater at a temperature of not less than 100˚C is particularly desirable in terms of preventing the occurrence of hetero-phases.

In this embodiment, the p-layer of the first cell layer 91 is preferably an amorphous B-doped SiC film generated by reaction of $SiH_4$, $H_2$, $CH_4$ and $B_2H_6$ gas using an RF plasma, and the film thickness is preferably not less than 4 nm and not more than 16 nm.

Furthermore, in this embodiment, the i-layer of the first cell layer 91 is preferably an amorphous Si film in a standard configuration, and is generated by reaction of $SiH_4$ and $H_2$ using an RF plasma. The film thickness is preferably not less than 100 nm and not more than 400 nm. Under standard film formation conditions, the amorphous i-layer can be formed by supplying $SiH_4$ and $H_2$ in a ratio of 1:5, controlling the pressure at 600 Pa, and conducting a discharge of 60 MHz high-frequency waves at 0.15 W/cm$^2$. The film formation rate under these standard film formation conditions can be set, for example, to 1.1 nm/s.

A layer formed using a lower power setting than the standard film formation conditions may be provided within the i-layer of the first cell layer 91 (for example, as an initial layer formed during the initial stages of the i-layer formation, or as a late-stage layer formed during the latter stages of the i-layer formation) as the hetero-phase-blocking layer of this embodiment. When forming this type of layer, the high-frequency wave output can be set to a low power such as 0.02 W/cm$^2$, and film formation then conducted at a slow rate. The film formation rate is, for example, approximately 0.2 nm/s. The initial layer or late-stage layer is formed, for example, for a period of 60 seconds (equivalent to a film thickness of 12 nm) to 120 seconds (equivalent to a film thickness of 24 nm). The i-layer provided with an initial layer or late-stage layer is formed as a continuous film, by altering the power during the plasma discharge.

Furthermore, in this embodiment, the n-layer of the first cell layer 91 (the top layer) is preferably a crystalline Si film (containing a crystalline component) in a standard configuration, and is generated by reaction of $SiH_4$, $H_2$, and $PH_3$ gas using an RF plasma. The Raman ratio of the lone n-layer film is not less than 2, and the film thickness is preferably not less than 10 nm and not more than 80 nm. Under standard film formation conditions, a microcrystalline n-layer (a film containing a mixture of crystalline and amorphous components) can be formed by supplying $SiH_4$, $H_2$, and $PH_3$ in a ratio of 1:80:0.02, controlling the pressure at 100 Pa, setting the spacing between the substrate and the electrode to 20 mm, and conducting a discharge of 60 MHz high-frequency waves at 0.3 $W/cm^2$. The film formation rate can be set, for example, to 0.2 nm/s.

An amorphous n-layer (with no crystalline component) may also be formed as the hetero-phase-blocking layer of this embodiment. In this case, an amorphous n-layer is formed prior to the formation of the above crystalline n-layer. This amorphous n-layer is formed by supplying $SiH_4$, $H_2$, and $PH_3$ in a ratio of 1:1:0.05, controlling the pressure at 20 Pa, setting the spacing between the substrate and the electrode to 20 mm, and conducting a discharge of 60 MHz high-frequency waves at 0.04 $W/cm^2$. The film formation rate can be set, for example, to 0.2 nm/s. When an amorphous Si n-layer and a microcrystalline Si n-layer are deposited, the discharge is temporarily halted, the flow rates and the pressure are adjusted, and once the system has stabilized, the discharge is recommenced. For example, a film of 15 nm can be formed under amorphous Si film formation conditions, and a film of 25 nm then formed under the standard crystalline film formation conditions.

A crystalline n-layer (containing a crystalline component) formed under a higher pressure than the standard film form conditions may also be formed as the hetero-phase-blocking layer of this embodiment. In this case, a microcrystalline n-layer (containing a mixture of crystalline and amorphous components) can be formed by supplying $SiH_4$, $H_2$, and $PH_3$ in a ratio of 1:80:0.02, controlling the pressure at 200 Pa, reducing the spacing between the substrate and the electrode to 10 mm, which represents 1/2 the spacing used in the standard conditions, and conducting a discharge of 60 MHz high-frequency waves at an output of 0.1 $W/cm^2$.

In this embodiment, a buffer layer (not shown in the figures) may be provided between the p-layer film and the i-layer film in order to improve the interface properties. By inserting a substance with an intermediate band gap as the buffer layer, band mismatch at the interface between the p-layer (SiC film) and the i-layer (Si film) can be suppressed. In this embodiment, whereas $SiH_4$, $H_2$, $CH_4$ and $B_2H_6$ are used as film formation gases for the p-layer, only $SiH_4$ and $H_2$ are used for the i-layer, and consequently the concentration of the dopant ($B_2H_6$) and the concentration of the $CH_4$ used for band adjustment are adjusted. Specifically, by halting supply of $B_2H_6$ gas to the p-layer film formation chamber, so that the $B_2H_6$ supply is limited to the quantity adsorbed to the chamber walls, and reducing the $CH_4$ gas supply rate to a value that is 1/10 to 1/3 that used for the p-layer, a buffer layer with a film thickness of 0.02 to 0.1 $\mu$m is formed. As a result, atomic diffusion into the p-layer and the i-layer generates a state in which the carbon content and the band energy structure vary smoothly through the direction of the film thickness, thereby improving the properties of the interface between the p-layer and the i-layer.

Subsequently, the same method and film formation conditions as those employed in the first embodiment are used to sequentially form a microcrystalline p-layer, microcrystalline i-layer and microcrystalline n-layer, each formed from a thin film of microcrystalline silicon, on top of the first cell layer (the top layer) 91, thereby forming a second cell layer (a bottom layer) 92 identical to that of the first embodiment.

In a similar manner to the first embodiment, and with the objective of forming a semi-reflective film to achieve electrical current consistency between the first cell layer (the top layer) 91 and the second cell layer (the bottom layer) 92 , a ZnO-based film (such as a GZO (Ga-doped ZnO) film) with a film thickness of not less than 0 nm and not more than 90 nm, and preferably not less than 5 nm and not more than 50 nm, may be formed as an intermediate contact layer 93 using a sputtering apparatus. In this intermediate contact layer 93, the light absorption for the lone ZnO film within a range from $\lambda$ = 450 nm to 1,000 nm is preferably less than 1%.

Following formation of the second cell layer 92, a solar cell panel 50 is completed using the same method as that shown in FIG. 4(e) to FIG. 7(b) for the first embodiment. Subsequently, the same method as that shown in FIG. 7 (c) and (d) is used to conduct an electric power generation test, other tests for evaluating specific performance factors, and evaluation of various specific performance factors including the external appearance.

The above embodiment describes a solar cell using the example of a tandem solar cell having an amorphous silicon-based photovoltaic layer as the top cell and a crystalline (microcrystalline) silicon-based photovoltaic layer as the bottom cell, but the present invention is not limited to this example.

For example, the present invention can also be applied in a similar manner to other types of thin-film solar cells, including single solar cells containing only an amorphous silicon-based photovoltaic layer, and multi-junction solar cells in which either one, or two or more, other photovoltaic layers are provided in addition to the top cell and bottom cell described above.

[Examples, Reference Examples, and Comparative Example]

Reference Example 1:

A structure containing only micro-texture was used as the transparent electrode-bearing substrate. The height of the protrusions within the micro-texture was not less than 0.1 $\mu$m and not more than 0.2 $\mu$m, the pitch was not less than 0.1 $\mu$m and not more than 0.3 $\mu$m, the ratio of height/base diameter for the protrusions was from 0.7 to 1.0, the spectral haze ratio was 20% at a wavelength of 550 nm, and the spectral haze ratio was 3% at 800 nm. With the exception of this difference in the transparent electrode-bearing substrate, a tandem solar cell was produced in accordance with the standard film formation conditions described in the above embodiment of the present invention.

In terms of the various layers formed on the transparent electrode-bearing substrate, the top cell p-layer had a film thickness of 8 nm, the top cell n-layer had a film thickness of 40 nm, the bottom cell p-layer had a film thickness of 30 nm, the bottom cell n-layer had a film thickness of 30 nm, the ZnO layer of the back electrode had a film thickness of 80 nm, and the Ag layer of the back electrode had a film thickness of 300 nm, and these values were kept the same for each of the reference examples, the comparative example, and each of the examples. The film thickness values and film formation conditions for the top cell i-layer and the top cell n-layer for this example were as shown in Table 3, and an intermediate contact layer was not formed.

The film formation conditions for each of the reference examples, the comparative example, and the examples shown in Table 3 were as detailed below.
Standard film formation conditions for top cell i-layer: an amorphous i-layer was formed by supplying $SiH_4$ and $H_2$ in a ratio of 1:5, controlling the pressure at 600 Pa, and conducting a discharge of 60 MHz high-frequency waves at an output of 0.15 W/cm$^2$. The film formation rate was 1.1 nm/s.

Low-speed film formation conditions for initial layer or late-stage layer of top cell i-layer: only the high-frequency wave output was altered from the standard conditions, and was set to 0.02 W/cm$^2$. The film formation rate was 0.2 nm/s. Deposition in combination with the film formed under the standard film formation conditions was conducted via continuous film formation, by altering the power during the plasma discharge.

Standard film formation conditions for top cell n-layer: a microcrystalline n-layer (a film containing a mixture of crystalline and amorphous components) was formed by supplying $SiH_4$, $H_2$, and $PH_3$ in a ratio of 1:80:0.02, controlling the pressure at 100 Pa, setting the spacing between the substrate and the electrode to 7 mm, and conducting a discharge of 60 MHz high-frequency waves at an output of 0.3 W/cm$^2$. The film formation rate was set to 0.2 nm/s.

Film formation conditions for amorphous Si top cell n-layer: an amorphous Si n-layer (containing no crystalline component) was formed by supplying $SiH_4$, $H_2$, and $PH_3$ in a ratio of 1:1:0.05, controlling the pressure at 20 Pa, setting the spacing between the substrate and the electrode to 7 mm, and conducting a discharge of 60 MHz high-frequency waves at 0.04 W/cm$^2$. The film formation rate was set to 0.2 nm/s. When an amorphous Si n-layer and a microcrystalline Si n-layer were deposited, the discharge was temporarily halted, the flow rates and the pressure were adjusted, and once the system had stabilized, the discharge was recommenced.

High-pressure film formation conditions for top cell n-layer: a microcrystalline Si n-layer (containing a mixture of crystalline and amorphous components) was formed by supplying $SiH_4$, $H_2$, and $PH_3$ in a ratio of 1:80:0.02, controlling the pressure at 200 Pa, reducing the spacing between the substrate and the electrode to 10 mm, which represents 1/2 the spacing used in the standard conditions, and conducting a discharge of 60 MHz high-frequency waves at 0.3 W/cm$^2$.

The cell performance of the solar cell obtained in the reference example 1 is shown in Table 4. The electric power generation efficiency (the initial value) for the solar cell of this example, in which the film thickness of the bottom cell i-layer was set to 2 $\mu$m relative to a film thickness for the top cell i-layer of 300 nm, was 12%.
In Table 4, the evaluation items for the cell performance labeled Isc, Voc, FF, and Eff refer to the short-circuit electrical current, the open-circuit voltage, the fill factor, and the electric power generation efficiency (the initial value) respectively. Furthermore, in the reference examples, the comparative example, and the examples shown in Table 4, the results of the cell performance are recorded as relative values, with the results for the reference example 1 set to 1. These results represent initial values prior to any degradation, but the rate of degradation is thought to be similar for the scope of these tests, meaning provided the results are presented as relative values, the values following degradation will be similar.

Reference Example 2:

With the exceptions of forming the top cell i-layer and the bottom cell i-layer with the film thickness values shown in Table 3, a tandem solar cell was produced using the same method as the reference example 1.
The cell performance of the obtained solar cell is shown in Table 4. The electric power generation efficiency for the solar cell of this example, in which the film thickness of the bottom cell i-layer was set to 1.5 $\mu$m relative to a film thickness for the top cell i-layer of 300 nm, decreased to 10.8%. This decrease was due to a significant fall in the electric power generation current, and confirmed that for the substrate used in the reference examples, the desired electrical current could not be obtained unless the film thickness of the bottom cell was at least 2 $\mu$m.

Comparative Example 4:

A tandem solar cell was produced in accordance with the standard film formation conditions described in the above embodiment of the present invention. A similar substrate to the example 6, comprising a mixture of macro-texture and micro-texture, was used as the transparent electrode-bearing substrate. The film thickness values and film formation conditions for the top cell i-layer and the top cell n-layer for this example were as shown in Table 3, and an intermediate contact layer was not formed. In other words, the top cell i-layer was formed with a film thickness of 300 nm at a film formation rate of 1.1 nm/s, and the top cell n-layer was formed with a film thickness of 40 nm under conditions that produced a microcrystalline film comprising a mixture of crystalline and amorphous components. The film thickness of the bottom cell i-layer was 1.5 $\mu$m.

The cell performance of the obtained solar cell is shown in Table 4. As shown in Table 4, although the solar cell of this example exhibited a large increase in electrical current, the open-circuit voltage and the fill factor decreased, and the initial value of the electric power generation efficiency was lower than that of the reference example 1 where the film thickness of the bottom cell i-layer was 2 $\mu$m.

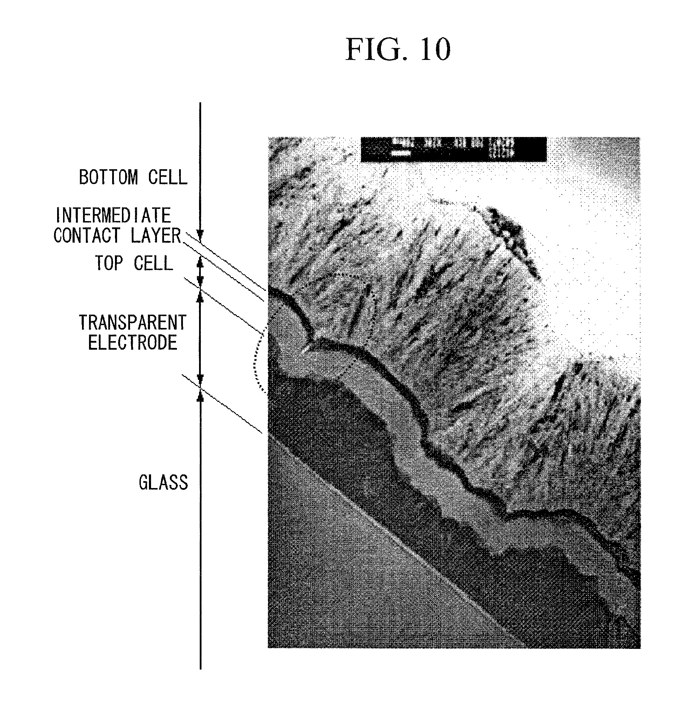

The reasons that the open-circuit voltage and fill factor decreased for the solar cell of the comparative example 4 were investigated. FIG. 10 shows a transmission electron microscope photograph of a cross-section of a tandem solar cell produced using a transparent electrode-bearing substrate comprising a mixture of macro-texture and micro-texture. In this electron microscope photograph, a line that penetrates through the top cell from top to bottom can be seen near a valley portion of the transparent electrode (the portion encircled with a dotted line). This represents a discontinuous boundary, which appears as a line, between film growth phases formed and grown on surfaces adjacent to the underlying film, and is called a hetero-phase. Carrier recombination is thought to be concentrated at these hetero-phases, meaning they correspond with sites of current leakage. The open-circuit voltage and the fill factor decreased when these hetero-phases occurred. Accordingly, the inventors of the present invention thought that if these hetero-phases could be suppressed, or even if they could not be completely suppressed, if hetero-phases penetrating from the transparent electrode through the top cell could be blocked before reaching the intermediate contact layer or bottom cell, then decreases in the open-circuit voltage and fill factor should be able to be suppressed.

Example 6 to Example 9

With the exceptions of setting the film thickness values and the film formation conditions for the top cell i-layer and the top cell n-layer as shown in Table 3, tandem solar cells of the example 6 through example 9 were produced using the same method as the above comparative example 4.
The cell performance of each of the obtained solar cells is shown in Table 4.

In the example 6, by conducting only the initial stage of the film formation of the amorphous Si i-layer of the top cell (at the interface with the p-layer) at low power, decreases in the open-circuit voltage and the fill factor were suppressed, enabling the performance of the solar cell to be improved. It is thought that this effect is because the initial layer of the amorphous Si i-layer was able to block hetero-phases from penetrating the top cell, thereby suppressing current leakage. The fact that a high efficiency indicated by an initial value for the electric power generation efficiency of 13.0% was able to be obtained with a thin-film bottom cell with a film thickness of 1.5 $\mu$m represents an extremely significant accomplishment in improving both the productivity and the efficiency.

In the example 7, by conducting only the latter stage of the film formation of the amorphous Si i-layer of the top cell (at the interface with the n-layer) at low power, decreases in the open-circuit voltage and the fill factor were suppressed, enabling the performance of the solar cell to be improved. It is thought that this effect is because the late-stage layer of the amorphous Si i-layer was able to block hetero-phases from penetrating the top cell, thereby suppressing current leakage. The fact that even in this example 7, a high efficiency indicated by an initial value for the electric power generation efficiency of 13.0% was able to be obtained with a thin-film bottom cell with a film thickness of 1.5 $\mu$m represents an extremely significant accomplishment in improving both the productivity and the efficiency.

In the example 8, by conducting only the latter stage of film formation of the top cell n-layer under standard film formation conditions to form a crystalline layer, and forming an amorphous layer during the initial stage of the film formation, decreases in the open-circuit voltage and the fill factor were suppressed, enabling the performance of the solar cell to be improved. It is thought that this effect is because the initial amorphous layer in the top cell n-layer was able to fill any hetero-phases at the interface with the i-layer, thereby blocking hetero-phases from penetrating the top cell, and suppressing current leakage. The fact that an initial value for the electric power generation efficiency of 13.2% was obtained with a thin-film bottom cell with a film thickness of 1.5 $\mu$m reflects a combination of a similar hetero-phase-blocking effect to that observed in the example 6 and example 7, and an interface improvement effect provided by the n-layer.

In the example 9, by forming the top cell n-layer under high-pressure conditions at 200 Pa, thereby forming a microcrystalline film, decreases in the open-circuit voltage and the fill factor were suppressed, enabling the performance of the solar cell to be improved. In the example 9, a similar effect was also obtained when the pressure during film formation of the top cell n-layer was set to 400 Pa. It is thought that this effect is due to the fact that by conducting the film formation at high pressure, the top cell n-layer was able to more readily attach to valley portions at the interface with the i-layer, and that as a result, hetero-phases could be blocked from penetrating through the top cell, thereby suppressing current leakage.

Table 3

| | Film thickness and film formation conditions for top cell i-layer | Film thickness and film formation conditions for top cell n-layer |
| --- | --- | --- |
| Reference example 1 | 300 nm under standard film formation conditions | 2 $\mu$m under standard film formation conditions |
| Reference example 2 | 300 nm under standard film formation conditions | 1.5 $\mu$m under standard film formation conditions |
| Comparative example 4 | 300 nm under standard film formation conditions | 40 nm under standard film formation conditions (crystalline) |
| Example 6 | Initial layer: 24 nm (120 seconds) under low-speed film formation conditions; followed by the remaining 276 nm under standard film formation conditions | 40 nm under standard film formation conditions (crystalline) |
| Example 7 | 276 nm under standard film formation conditions; followed by 24 nm (120 seconds) under low-speed film formation conditions as a late-stage layer | 40 nm under standard film formation conditions (crystalline) |
| Example 8 | 300 nm under standard film formation conditions | 15 nm under amorphous Si film formation conditions; followed by 25 nm under standard film formation |
| Example 9 | 300 nm under standard film formation conditions | 40 nm under high-pressure film formation conditions (crystalline) |

Example 10:

With the exception of subjecting the transparent electrode surface of the transparent electrode-bearing substrate to an ion treatment, a tandem solar cell of the example 10 was produced using the same method as the above comparative example 4.

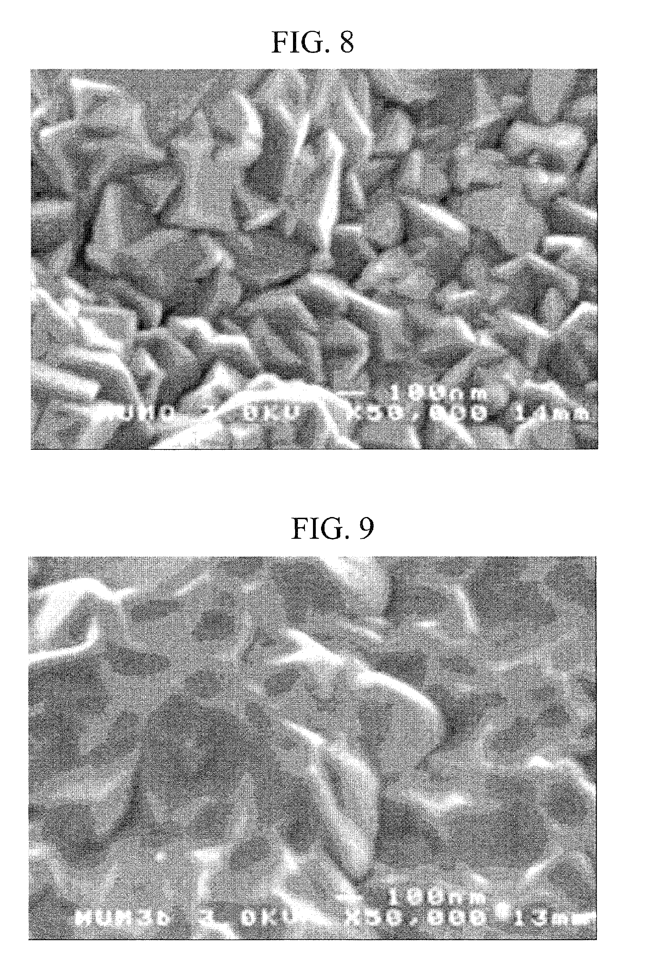

This ion treatment involved conducting ion etching by the irradiation of argon ions within a vacuum, and an ion milling apparatus with a filament type ion source was used as the treatment apparatus. The inside of the chamber was evacuated to a vacuum in the order of $10^{-4}$ Pa, argon gas was supplied to the chamber and Ar ions were generated under conditions at $5 \times 10^{-3}$ Pa, and ion irradiation was then conducted at an accelerating voltage of 1 kV to effect the ion treatment. The ions were irradiated perpendicularly onto the surface of the transparent electrode of the transparent electrode-bearing substrate, and the irradiation time was set to 180 seconds. FIG. 8 is an electron microscope photograph (magnification: 50,000$\times$) of the surface of the transparent electrode of the transparent electrode-bearing substrate prior to the ion treatment, and FIG. 9 is an electron microscope photograph (magnification: 50,000$\times$) of the surface of the transparent electrode of the transparent electrode-bearing substrate following the ion treatment.

The cell performance of the obtained solar cell is shown in Table 4. In Table 4, the evaluation items for the cell performance labeled Isc, Voc, FF, and Eff refer to the short-circuit electrical current, the open-circuit voltage, the fill factor, and the electric power generation efficiency respectively. The (a-Si/c-Si) values for Isc refer to the Isc value for the a-Si (amorphous) top cell, and the Isc value for the c-Si (crystalline) bottom cell, determined from the spectral sensitivity.

In the example 10, as a result of the ion treatment, decreases in the open-circuit voltage and the fill factor were suppressed, enabling the performance of the solar cell to be improved. It is thought that this effect is because the ion treatment smoothes out the shape of the texture on the substrate, thereby suppressing the formation of hetero-phases in the top cell and suppressing current leakage.

In the examples 1 to 10, the film formation conditions for the bottom cell i-layer were fixed, and as shown in Table 1, the Raman ratio following film formation of the bottom cell n-layer was within a range from 5.0 to 7.0.

Example 11:

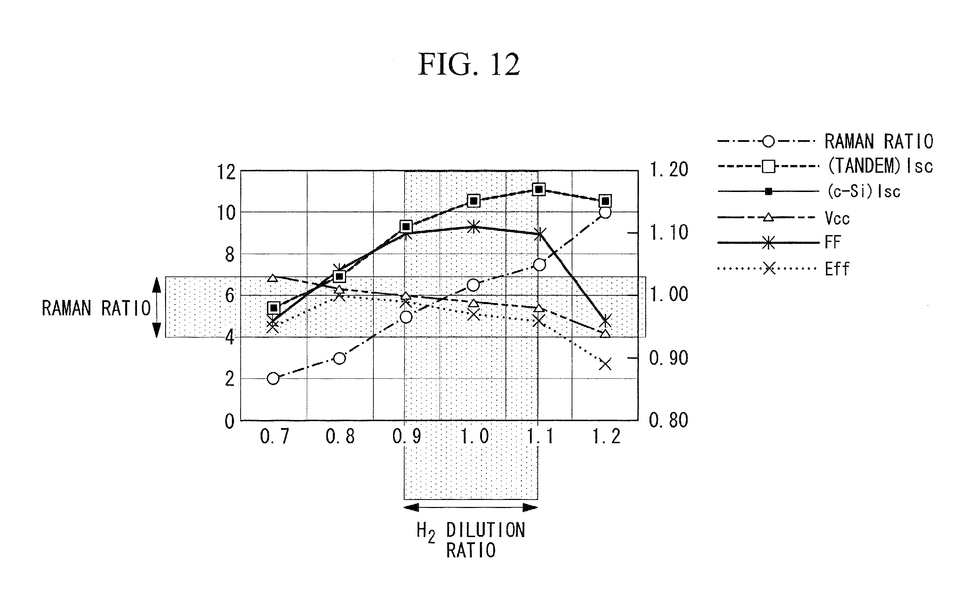

With the exception of altering the $H_2/SiH_4$ dilution ratio for the bottom cell i-layer in the manner shown in Table 5, tandem solar cells of the example 11(1) through example 11(6) were formed using the same method as the example 1, and the relationship between the Raman ratio following film formation of the bottom cell n-layer, and the solar cell performance was investigated. The results are shown in FIG. 12. In Table 5 and FIG. 12, the $H_2$ dilution ratio and the solar cell performance results are recorded as relative values, with the results for the comparative example 1 set to 1. These results represent initial values prior to any degradation, but the rate of degradation is thought to be similar for the scope of these tests, meaning provided the results are presented as relative values, the values following degradation will be similar.

As is evident from Table 5 and FIG. 12, when the Raman ratio following film formation of the n-layer is not less than 3.0 and not more than 8.0, the solar cell performance improves beyond that of the comparative example 1. It is thought that this observation is due to the fact that if the Raman ratio falls below 3.0, then although the Voc increases, the fact that the Isc value decreases markedly suggests that the quantity of amorphous components has become overly high, causing resistance loss. If the Raman ratio exceeds 8.0, then it is thought that the fact that the Voc and FF values decrease significantly suggests that voltage loss due to current leakage has occurred, and this is assumed to be current leakage at the crystal grain boundaries. In the second cell layer, the presence of an appropriate amorphous phase enables defects that exist at the grain boundaries of the crystalline silicon to be deactivated, and this is thought to contribute to the suppression of decreases in the Isc value.

Furthermore, in FIG. 12, the increase in the Eff eases at a $H_2$ dilution ratio of 0.9, and the Eff starts to decrease at a $H_2$ dilution ratio of 1.1. As shown in the Example 11(3) through example 11(5), the Eff value when the $H_2$ dilution ratio is not less than 0.9 and not more than 1.1 represents a performance of at least 1.1 times that of the comparative example 1. Accordingly, based on the correlation between the $H_2$ dilution ratio and the solar cell performance, the optimum Raman ratio is determined experimentally as being not less than 5.0 and not more than 7.5.

Table 4

|  | Cell Performance | | | |
|---|---|---|---|---|
|  | Isc (a-Si/c-Si) | Voc | FF | Eff |
| Reference example 1 | 1 (1/1) | 1 | 1 | 1 |
| Reference example 2 | 0.89 (1/0.89) | 1 | 1 | 0.89 |
| Comparative example 4 | 1.10 (1/1.10) | 0.95 | 0.92 | 0.97 |
| Example 6 | 1.10 (1/1.10) | 0.99 | 0.99 | 1.08 |
| Example 7 | 1.10 (1/1.10) | 0.99 | 0.99 | 1.08 |
| Example 8 | 1.10 (1/1.10) | 1.00 | 1.00 | 1.01 |
| Example 9 | 1.10 (1/1.10) | 0.99 | 0.98 | 1.07 |
| Example 10 | 1.03 (1/1.03) | 1.01 | 1.01 | 1.05 |

Table 5

| No. | $H_2$ dilution ratio | Raman ratio | Cell performance | | | | |
|---|---|---|---|---|---|---|---|
|  |  |  | (Tandem) Isc | (c-Si) Isc | Voc | FF | Eff |
| Example 11(1) | 0.8 | 2 | 0.98 | 0.98 | 1.03 | 0.95 | 0.96 |
| Example 11(2) | 0.8 | 3 | 1.03 | 1.03 | 1.01 | 1.00 | 1.04 |
| Example 11(3) | 0.9 | 5 | 1.11 | 1.11 | 1.00 | 0.99 | 1.10 |
| Example 11(4) | 1.0 | 6.5 | 1.15 | 1.15 | 0.99 | 0.97 | 1.11 |

(continued)

| No. | H₂ dilution ratio | Raman ratio | Cell performance | | | | |
|---|---|---|---|---|---|---|---|
| | | | (Tandem) Isc | (c-Si) Isc | Voc | FF | Eff |
| Example 11(5) | 1.1 | 7.5 | 1.17 | 1.17 | 0.98 | 0.96 | 1.10 |
| Example 11(6) | 1.2 | 10 | 1.15 | 1.15 | 0.94 | 0.89 | 0.96 |
| Comparative example 1 | 1.0 | 6.5 | 1.00 | 1.00 | 1.00 | 1.00 | 1.00 (12%) |

In the foregoing description, in the example 6 through example 11, decreases in the open-circuit voltage and fill factor were able to be suppressed even when a transparent electrode-bearing substrate with an increased spectral haze ratio was used, and by using a thin bottom cell, a tandem solar cell that combined high efficiency with a high level of productivity was able to be produced.

If the entire top cell (an amorphous Si layer) is formed at low power, then because the film formation rate decreases markedly, the productivity deteriorates. However, if only the initial or last approximately 20% of the film thickness is produced at low power, as in the above example 6 and example 7, then any deterioration in productivity can be suppressed dramatically, enabling solar cells to be produced at a high level of productivity. Furthermore, when the film formation conditions for the n-layer are improved, as in the example 9, then absolutely no deterioration in productivity occurs, and solar cells can be produced at a high level of productivity.

## Claims

1. A photovoltaic device comprising at least a transparent electrode-bearing substrate, prepared by providing a transparent electrode layer on a transparent, electrically insulating substrate, and a photovoltaic layer comprising mainly crystalline silicon-based semiconductors and a back electrode layer formed sequentially on the transparent electrode layer of the transparent electrode-bearing substrate, wherein
the transparent electrode-bearing substrate has a surface shape comprising a mixture of coarse and fine roughness, and exhibits a spectral haze ratio of 20% or greater for wavelengths of not less than 550 nm and not more than 800 nm, and
the photovoltaic layer comprising mainly crystalline silicon-based semiconductors has a film thickness of not less than 1.2 $\mu$m and not more than 2 $\mu$m, and a Raman ratio of not less than 3.0 and not more than 8.0.

2. The photovoltaic device according to claim 1, further comprising a photovoltaic layer comprising mainly amorphous silicon-based semiconductors between the transparent electrode-bearing substrate and the photovoltaic layer comprising mainly crystalline silicon-based semiconductors.

3. The photovoltaic device according to claim 2, further comprising an intermediate contact layer between the photovoltaic layer comprising mainly amorphous silicon-based semiconductors and the photovoltaic layer comprising mainly crystalline silicon-based semiconductors.

4. The photovoltaic device according to any one of claims 1 through 3, wherein a surface of the transparent electrode of the transparent electrode-bearing substrate comprises a plurality of ridges and a plurality of flat portions, surfaces of the ridges and flat portions comprise a multitude of continuous micro-protrusions,
a height of the ridges in a direction perpendicular to the substrate surface is not less than 0.4 $\mu$m and not more than 0.7 $\mu$m,
a number of ridges within a 10 $\mu$m square area of the substrate surface is not less than 15 and not more than 50, a base diameter of the multitude of micro-protrusions is not less than 0.1 $\mu$m and not more than 0.3 $\mu$m, and a ratio of height/base diameter for the micro-protrusions is not less than 0.7 and not more than 1.2.

5. A process for producing a photovoltaic device comprising: preparing a transparent electrode-bearing substrate by forming a transparent electrode layer on a transparent, electrically insulating substrate; and
sequentially forming at least a photovoltaic layer comprising mainly amorphous silicon-based semiconductors and a back electrode layer on the transparent electrode layer of the transparent electrode-bearing substrate, wherein the transparent electrode-bearing substrate has a surface shape comprising a mixture of coarse and fine roughness, and exhibits a spectral haze ratio of 20% or greater for wavelengths of not less than 550 nm and not more than 800 nm, and

a hetero-phase-blocking layer that blocks hetero-phases from penetrating through the photovoltaic layer comprising mainly amorphous silicon-based semiconductors from a surface on the transparent electrode layer side to a surface on the back electrode layer side is formed within the photovoltaic layer.

6. The process for producing a photovoltaic device according to claim 5, wherein during formation of the photovoltaic layer comprising mainly amorphous silicon-based semiconductors, a p-layer, an i-layer and an n-layer are formed sequentially, and

the hetero-phase-blocking layer is formed during formation of the i-layer, by forming a portion of the i-layer at a slower rate than other portions of the i-layer.

7. The process for producing a photovoltaic device according to claim 5, wherein during formation of the photovoltaic layer comprising mainly amorphous silicon-based semiconductors, a p-layer, an i-layer and an n-layer are formed sequentially, and

the hetero-phase-blocking layer is formed during formation of the n-layer, by forming an amorphous layer within at least a portion of the n-layer.

8. The process for producing a photovoltaic device according to claim 5, wherein during formation of the photovoltaic layer comprising mainly amorphous silicon-based semiconductors, a p-layer, an i-layer and an n-layer are formed sequentially, and

the hetero-phase-blocking layer is formed during formation of the n-layer, by forming at least a portion of the n-layer under pressure of not less than 200 Pa.

9. A process for producing a photovoltaic device comprising: preparing a transparent electrode-bearing substrate by forming a transparent electrode layer on a transparent, electrically insulating substrate; and

sequentially forming at least a photovoltaic layer comprising mainly amorphous silicon-based semiconductors and a back electrode layer on the transparent electrode layer of the transparent electrode-bearing substrate, wherein the transparent electrode-bearing substrate has a surface shape comprising a mixture of coarse and fine roughness, and exhibits a spectral haze ratio of 20% or greater for wavelengths of not less than 550 nm and not more than 800 nm, and

a hetero-phase prevention layer that prevents the formation of hetero-phases that penetrate through the photovoltaic layer from the surface on the transparent electrode layer side to the surface on the back electrode layer side is formed between formation of the transparent electrode layer and formation of the photovoltaic layer.

10. The process for producing a photovoltaic device according to claim 9, wherein the hetero-phase prevention layer is formed by smoothing the protrusions of the transparent electrode layer.

11. The process for producing a photovoltaic device according to either claim 9 or 10, wherein the hetero-phase prevention layer is formed by subjecting the transparent electrode layer surface to an ion treatment.

12. The process for producing a photovoltaic device according to any one of claims 5 through 11, wherein a photovoltaic layer comprising mainly crystalline silicon-based semiconductors is formed between the photovoltaic layer comprising mainly amorphous silicon-based semiconductors and the back electrode.

13. A photovoltaic device comprising at least a transparent electrode-bearing substrate, prepared by providing a transparent electrode layer on a transparent, electrically insulating substrate, and a photovoltaic layer comprising mainly amorphous silicon-based semiconductors and a back electrode layer formed sequentially on the transparent electrode layer of the transparent electrode-bearing substrate, wherein

the transparent electrode-bearing substrate has a surface shape comprising a mixture of coarse and fine roughness, and exhibits a spectral haze ratio of 20% or greater for wavelengths of not less than 550 nm and not more than 800 nm, and

a hetero-phase-blocking layer that blocks hetero-phases from penetrating through the photovoltaic layer comprising mainly amorphous silicon-based semiconductors from a surface on the transparent electrode layer side to a surface on the back electrode layer side is provided within the photovoltaic layer.

14. The photovoltaic device according to either claim 2 or 13, wherein

during formation of the photovoltaic layer comprising mainly amorphous silicon-based semiconductors, a p-layer, an i-layer and an n-layer are formed sequentially, and

the n-layer of the photovoltaic layer comprising mainly amorphous silicon-based semiconductors is formed from a layer comprising mainly amorphous silicon-based semiconductors, and a layer comprising mainly crystalline silicon-based semiconductors.

15. The photovoltaic device according to any one of claims 2, 13 and 14, wherein a buffer layer is provided between the p-layer and the i-layer of the photovoltaic layer comprising mainly amorphous silicon-based semiconductors.

16. The photovoltaic device according to claim 13, further comprising a photovoltaic layer comprising mainly crystalline silicon-based semiconductors between the photovoltaic layer comprising mainly amorphous silicon-based semiconductors and the back electrode layer.

17. The photovoltaic device according to claim 16, wherein the photovoltaic layer comprising mainly crystalline silicon-based semiconductors has a film thickness of not less than 1.2 $\mu$m and not more than 2 $\mu$m, and a Raman ratio of not less than 3.0 and not more than 8.0.

18. The photovoltaic device according to claim 13, further comprising a photovoltaic layer, which comprises mainly a crystalline silicon-based semiconductor, and a crystalline or amorphous silicon-germanium-based semiconductor, between the photovoltaic layer comprising mainly amorphous silicon-based semiconductors and the back electrode layer.

19. The photovoltaic device according to claim 13, further comprising a photovoltaic layer, which comprises mainly a crystalline or amorphous silicon-based semiconductor, and a crystalline or amorphous silicon-germanium-based semiconductor, between the photovoltaic layer comprising mainly amorphous silicon-based semiconductors and the back electrode layer.

# FIG. 1

90 ; PHOTOVOLTAIC DEVICE

1 ; SUBSTRATE

2 ; TRANSPARENT ELECTRODE LAYER

P

i — 91 ; FIRST CELL LAYER (TOP LAYER)

n

93 ; TRANSPARENT ELECTRODE (INTERMEDIATE CONTACT LAYER)

P

i — 92 ; SECOND CELL LAYER (BOTTOM LAYER)

n

3 ; PHOTOVOLTAIC LAYER

4 ; BACK ELECTRODE LAYER

EP 2 133 924 A1

FIG. 2

FIG. 3

# FIG. 4

（a）　　　（b）　　　（c）　　　（d）　　　（e）

1　　　　1　　　　1　　10　　　　1　　10　　　　1　　10

LASER

2　　　　2　　　　2　　　　2　11　3　　2　LASER　3

11

# FIG. 5

EP 2 133 924 A1

（a）

1
10

2  11  4  3

（b）

LASER

1  10

2  11  4  3
12

（c）

12  10  1  LASER

2  3  11  4  15

## FIG. 6

( a )                    ( b )

# FIG. 7

(a)　　　　(b)　　　　(c)　　　　(d)

24　23

LIGHT

50

FIG. 8

FIG. 9

# FIG. 10

BOTTOM CELL

INTERMEDIATE
CONTACT LAYER

TOP CELL

TRANSPARENT
ELECTRODE

GLASS

FIG. 11

HETERO-PHASE BLOCKED
PARTWAY THROUGH
AMORPHOUS Si i-LAYER

# FIG. 12

**INTERNATIONAL SEARCH REPORT**

| International application No. |
| --- |
| PCT/JP2007/065386 |

A.   CLASSIFICATION OF SUBJECT MATTER
*H01L31/04*(2006.01)i

According to International Patent Classification (IPC) or to both national classification and IPC

B.   FIELDS SEARCHED

Minimum documentation searched (classification system followed by classification symbols)
H01L31/04

Documentation searched other than minimum documentation to the extent that such documents are included in the fields searched
Jitsuyo Shinan Koho          1922-1996     Jitsuyo Shinan Toroku Koho     1996-2007
Kokai Jitsuyo Shinan Koho     1971-2007     Toroku Jitsuyo Shinan Koho     1994-2007

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| Y | JP 2005-347490 A  (Asahi Glass Co., Ltd.), 15 December, 2005 (15.12.05), Full text; all drawings (Family: none) | 1-4,14,15 |
| Y | JP 2002-26348 A  (Mitsubishi Heavy Industries, Ltd.), 25 January, 2002 (25.01.02), Par. No. [0036] (Family: none) | 1-4,14,15 |
| Y | JP 2006-216921 A  (Mitsubishi Heavy Industries, Ltd.), 17 August, 2006 (17.08.06), Par. No. [0044]; Fig. 5 (Family: none) | 1-4,14,15 |

| ☒ | Further documents are listed in the continuation of Box C. | ☐ | See patent family annex. |

| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 30 October, 2007 (30.10.07) | 13 November, 2007 (13.11.07) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2007/065386 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2007-5345 A  (Mitsubishi Heavy Industries, Ltd.), <br> 11 January, 2007 (11.01.07), <br> Par. No. [0041]; Fig. 15 <br> (Family: none) | 1-4,14,15 |

Form PCT/ISA/210 (continuation of second sheet) (April 2007)

**INTERNATIONAL SEARCH REPORT**

| International application No. |
| --- |
| PCT/JP2007/065386 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
 A matter common to the inventions in claims 1-19 is "a photoelectric converter comprising a substrate with a transparent electrode where a transparent electrode layer is provided on a transparent insulating substrate, and at least a photoelectric conversion layer principally comprising a silicon based semiconductor and a backside electrode layer that are formed sequentially on the transparent electrode layer side of the substrate with a transparent electrode, wherein the substrate with a transparent electrode has a surface shape where large and small protrusions and recesses coexist and spectral haze rate is 20% or above at the wavelength of 550-800 nm.
                    (Continued to extra sheet.)

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.: 1-4, 14, 15

**Remark on Protest**      ☐ The additional search fees were accompanied by the applicant's protest and, where applicable,
the                              payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**INTERNATIONAL SEARCH REPORT**

International application No.

PCT/JP2007/065386

Continuation of Box No.III of continuation of first sheet(2)

However, our search has found the above "photoelectric converter" is disclosed in Japanese Laid-open No. 2005-347490, and therefore it is not clearly novel. Consequently the common matter is not a special technical feature within the meaning of PCT Rule 13.2, second sentence, because the above "photoelectric converter" makes no contribution over the prior art.

Therefore, there is no matter common to all the inventions in claims 1-19 as a special technical feature, and there exists no other common matter to be considered to be a special technical feature within the meaning of PCT Rule 13.2, second sentence, therefore no technical relationship within the meaning of PCT Rule 13 can be found among those different inventions.

Accordingly, the inventions in claims 1-19 do not fulfill the requirement of unity of invention.

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03036657A1 PCT

- JP 2005347490 A